(19) Europäisches Patentamt
European Patent Office
Office européen des brevets

(11) EP 2 085 741 A1

(12) **EUROPEAN PATENT APPLICATION**
published in accordance with Art. 153(4) EPC

(43) Date of publication:
05.08.2009 Bulletin 2009/32

(51) Int Cl.:
*G01B 11/02* (2006.01)     *G03F 7/20* (2006.01)
*H01L 21/027* (2006.01)

(21) Application number: 07828672.1

(22) Date of filing: 28.09.2007

(86) International application number:
PCT/JP2007/068930

(87) International publication number:
WO 2008/038751 (03.04.2008 Gazette 2008/14)

(84) Designated Contracting States:
AT BE BG CH CY CZ DE DK EE ES FI FR GB GR
HU IE IS IT LI LT LU LV MC MT NL PL PT RO SE
SI SK TR

(30) Priority: 28.09.2006 JP 2006265848

(71) Applicant: Nikon Corporation
Tokyo 100-8331 (JP)

(72) Inventor: MIYASHITA, Kazuyuki
Tokyo 100-8331 (JP)

(74) Representative: HOFFMANN EITLE
Patent- und Rechtsanwälte
Arabellastraße 4
81925 München (DE)

(54) **LINE WIDTH MEASURING METHOD, IMAGE FORMING STATUS DETECTING METHOD, ADJUSTING METHOD, EXPOSURE METHOD AND DEVICE MANUFACTURING METHOD**

(57)     A pattern area that includes a plurality of line patterns with a predetermined spacing therebetween formed on a wafer is imaged, and based on the imaging results, a contrast value of an image of the pattern area is computed (step S8), and the computed contrast value is converted into the linewidth of the line pattern based on known conversion information (step S9). Therefore, even if the pattern area is imaged using a microscope having a low resolving power, e.g. an image-forming type alignment sensor or the like, without using the SEM, the linewidth of the line pattern can be measured with high precision. Accordingly, linewidth measurement with low cost and high throughput becomes possible.

*Fig. 4*

EP 2 085 741 A1

## Description

## TECHNICAL FIELD

The present invention relates to linewidth measuring methods, image-forming-state detecting methods, adjustment methods, exposure methods and device manufacturing methods, and more particularly, to a linewidth measuring method in which a linewidth of a pattern formed on an object is measured, an image-forming-state detecting method in which based on a measurement result obtained by measuring the linewidth of the pattern formed on the object via an optical system using the linewidth measuring method, a forming state of an image of a pattern including the pattern previously referred to is detected, an adjustment method in which the optical system is adjusted based on a detection result obtained in the image-forming-state detecting method, an exposure method in which a forming state of an image of a device pattern during exposure is adjusted based on a result obtained by detecting the forming state of the image of the pattern formed on the object using the image-forming-state detecting method, and a device manufacturing method makes use of the exposure method.

## BACKGROUND ART

The integration of the semiconductor devices (integrated circuits) is getting higher year by year, and accompanying the higher integration, capability of forming an image of a finer circuit pattern on an object such as a wafer with high precision (i.e. improvement of resolution), and also improvement of inter-shot linewidth uniformity and/or intra-shot linewidth uniformity, and the like have been required for a projection exposure apparatus such as a stepper or a scanning stepper, which is a manufacturing apparatus of semiconductor devices and the like. The inter-shot linewidth uniformity means uniformity of the linewidths of same patterns formed on a plurality of shot areas on a wafer, and the intra-shot linewidth uniformity means uniformity among the linewidths of a plurality of the same patterns distributed within a same shot area.

In order to improve the inter-shot linewidth uniformity and the intra-shot linewidth uniformity, it is important that the linewidth of the pattern or the pattern image (such as the resist image), and hence a forming state of pattern images can be measured with high precision and at high speed, and exposure conditions can be decided based on the measurement results, and hence an exposure apparatus can be adjusted, for example, optical characteristics of an optical system and the like can be adjusted.

As the measurement method of linewidths of pattern images that have been used conventionally, for example, there are methods such as a method in which a linewidth value of a pattern image (e.g. a resist image) formed on a wafer is directly measured with a scanning electron microscope (hereinafter, simply referred to as "SEM") for measurement, an electric dimension measurement method called ECD, in which a dimension value is obtained from a pattern resistance value after processing (e.g. refer to Patent Citation 1), and an optical CD (OCD) measurement that makes use of the scatterometry technology in which a sectional shape (linewidth, height, a taper angle, or the like) of a repetition pattern is obtained by analyzing scattered lights (diffracted lights) from the wafer surface. In the OCD measurement, an incident light is irradiated to a one-dimensional-grating-shaped pattern that has a periodic structure of line-and-space, and a pattern shape is obtained by analyzing a wavelength property and an incident angle property of the diffracted light, but it is difficult to directly obtain the pattern shape (e.g. linewidth) from measurement information (e.g. spectral information of interference fringes generated by interference of diffracted lights from the grating-shaped pattern, or the like), and therefore a library method is frequently used. In the library method, a theoretical value of a diffracted light with a possible shape is obtained in advance from simulation, and the linewidth that is subject to measurement is identified by pattern matching with the measurement value.

However, in the method in which the linewidth of a resist image is directly measured with the SEM, since the focusing of the SEM needs to be performed precisely, the measurement time per point is very long, and therefore several hours to several tens of hours are required for performing the measurement at a plurality of points. Further, since the measurement is performed in vacuum in the case of the SEM, the time for loading/unloading a wafer to the sample chamber is also required. Accordingly, it cannot be said that to perform the linewidth measurement of pattern images constantly using the SEM is a practical choice.

Further, while a high-speed measurement can be performed in the electric dimension measurement method described above, this measurement method has high running cots because costly special wafers need to be used and also a device to perform etching of the wafers becomes necessary.

Further, in the OCD described above, since the library method is employed, the shape can be measured (identified) only with a shape unit of internal models of the library, and therefore, enormous numbers of internal models and simulations of spectral distribution (diffracted light intensity distribution) become necessary to improve the resolving power. Further, in the OCD in the library method, a simulation result that most coincides with the diffracted light intensity distribution that has been measured is searched, and a shape of the pattern on a measurement wafer is identified with a shape that its model has. Accordingly, in the case of performing high-precision measurement, the number of the models owned as the library has to be increased, and therefore much time is required for preparing the library, and also the measurement time gets longer according to the increase of the number of the models, which decreases the throughput.

Patent Citation 1: U.S. Patent No. 4,908,656

## DISCLOSURE OF INVENTION

## MEANS FOR SOLVING THE PROBLEMS

The present invention has been made under the circumstances described above, and according to a first aspect of the present invention, there is provided a first linewidth measuring method of measuring a linewidth of a pattern formed on an object, the method comprising: an acquisition process in which a pattern area including the pattern formed on the object is imaged, and brightness/darkness information of an image of the pattern area is acquired based on a result of the imaging; and a conversion process in which the brightness/darkness information that has been acquired is converted into a linewidth of the pattern based on known conversion information.

With this method, the pattern area that includes the pattern formed on an object is imaged, and brightness/darkness information of an image of the pattern area is acquired based on the imaging result, and the acquired brightness/darkness information is converted into the linewidth of the pattern based on known conversion information. Therefore, even if the pattern area described above is imaged using a microscope having a low resolving power, e.g. an image-forming type alignment sensor of the exposure apparatus or the like, without using the SEM or the like, the linewidth of the pattern can be measured with high precision. Accordingly, linewidth measurement with low cost and high throughput becomes possible.

According to a second aspect of the present invention, there is provided a second linewidth measuring method of measuring a linewidth of a pattern formed on an object, the method comprising: detecting a pattern area that includes the pattern formed on the object with a first measurement device, and acquiring brightness/darkness information of the pattern area; and determining a linewidth of the pattern based on conversion information that is obtained using a second measurement device different from the first measurement device, and on the brightness/darkness information.

With this method, the conversion information is obtained in advance, and when performing measurement of the linewidth, brightness/darkness information of the pattern area that includes the pattern formed on an object is acquired by not using a device having a high resolving power such as the SEM but using a device having a low resolving power, which serves as the first measurement device. Accordingly, the linewidth of the pattern can be determined with high precision. Consequently, linewidth measurement with low cost and high throughput becomes possible.

According to a third aspect of the present invention, there is provided an image-forming-state detecting method, comprising: a process in which an object is exposed with an energy beam via an optical system, and an image of a pattern is formed on the object; a process in which a linewidth of the image of the pattern formed on the object is measured in one of the first and second linewidth measuring methods of the present invention; and a process in which a forming state of the image of the pattern is detected based on a result of the measurement.

With this method, the object is exposed with an energy beam via the optical system, an image of a pattern is formed on the object, and a linewidth of a line pattern formed on the object is measured with low cost and high throughput in one of the first and second linewidth measuring methods of the present invention, and based on the measurement result of the linewidth, a forming state of the image of the pattern is detected. Therefore, the forming state of the image of the pattern can be detected with high precision in a short period of time, in a state where the running cost is kept down.

According to a fourth aspect of the present invention, there is provided an adjustment method, comprising: a process in which a forming state of an image of a pattern formed on an object is detected in the image-forming-state detecting method of the present invention; and a process in which an optical system is adjusted based on a results of the detection.

With this method, in the image-forming-state detecting method of the present invention, a forming state of the image of the pattern is detected with high precision in a short period of time in a state where the running cost is kept down, and based on the detection result, the optical system is adjusted. Therefore, high-precision adjustment of the optical system with low cost and in a short period of time becomes possible.

According to a fifth aspect of the present invention, there is provided a first exposure method of exposing an object with an energy beam via an optical system and forming an image of a pattern on the object, the method comprising: a process in which a forming state of the image of the pattern formed at a plurality of positions on the object is detected using the image-forming-state detecting method of the present invention; and a process in which the forming state of the image of the pattern during the exposure is adjusted based on a result of the detection.

With this method, the forming state of the image of the pattern formed at a plurality of positions on the object is detected with high precision in a short period of time in a state where the running cost is kept down, by using the image-forming-state detecting method of the present invention, and based on the detection result, the forming state of the image of a device pattern during exposure is adjusted. Accordingly, high-precision generation of the pattern image on the object, that is, high-precision exposure is realized.

According to a sixth aspect of the present invention, there is provided a second exposure method of exposing an object with an energy beam via an optical system and forming an image of a pattern on the object, the method comprising: a process in which a linewidth of an image of the pattern formed on the object is measured in one of the first and second linewidth measuring methods of the present invention; and a process in which a forming state of the image of the pattern during the exposure is adjusted based on a result of the measurement.

With this method, the linewidth of the image of the pattern formed on the object is measured with low cost and high throughput in one of the first and second linewidth measuring methods of the present invention, and based on the measurement result, the forming state of the image of the pattern during exposure is adjusted. Accordingly, high-precision generation of the pattern image on the object, that is, high-precision exposure is realized.

According to a seventh aspect of the present invention, there is provided a third exposure method of exposing an object with an energy beam and forming a pattern on the object, the method comprising: measuring a linewidth of the pattern formed on the object by the exposure in one of the first and second linewidth measuring methods of the present invention; and determining an exposure condition of the object based on the linewidth that has been measured.

With this method, the linewidth of the image of the pattern formed on the object by exposure is measured with low cost and high throughput in one of the first and second linewidth measuring methods of the present invention, and based on the measured linewidth, exposure conditions of the object are determined. Accordingly, high-precision exposure of the object is realized.

In the lithography process, the productivity (including the yield) of microdevices can be improved by exposing the object in any one of the first to third exposure methods of the present invention. Consequently, according to an eighth aspect of the present invention, it can also be said that there is provided a device manufacturing method, including a lithography process in which an object is exposed in one of the first and second exposure methods of the present invention.

According to a ninth aspect of the present invention, there is provided a device manufacturing method that includes a process of exposing an object with an energy beam and a process of processing the object that has been exposed, the method comprising: measuring a linewidth of a pattern formed on the object by the exposure in one of the first and second linewidth measuring methods of the present invention; and determining a processing condition of the object in at least one of the exposing process and the processing process, based on the linewidth that has been measured.

**BRIEF DESCRIPTION OF THE DRAWINGS**

FIG. 1 is a view showing a schematic configuration of an exposure apparatus related to an embodiment.
FIG. 2 is a view showing an example of a reticle for measurement.
FIG. 3 is a view showing a configuration of a measurement pattern $MP_n$.
FIG. 4 is a flowchart showing a flow of operations for acquiring basic data to be used for measurement of linewidth of a pattern and transfer operations of transferring a device pattern to a predetermined number of wafers which is performed after the operations referred to previously.
FIG. 5 is a flowchart corresponding to a processing algorithm of a CPU inside a main controller of the exposure apparatus, which relates to making of a sample for linewidth measurement.
FIG. 6 is a flowchart corresponding to a processing algorithm of a CPU inside the main controller of the exposure apparatus, which relates to contrast measurement of a pattern image.
FIG. 7 is a flowchart showing a subroutine of acquiring contrast information in step 232 shown in FIG. 6.
FIG. 8 is a view showing a measurement wafer on which transferred images of the patterns of the reticle for measurement are formed in a plurality of shot areas.
FIG. 9 is a view showing an example of a resist image $MP_{i,n}'$ (i=1 to 15) that is respectively formed in each shot area $SA_i$ after the measurement wafer has been developed.

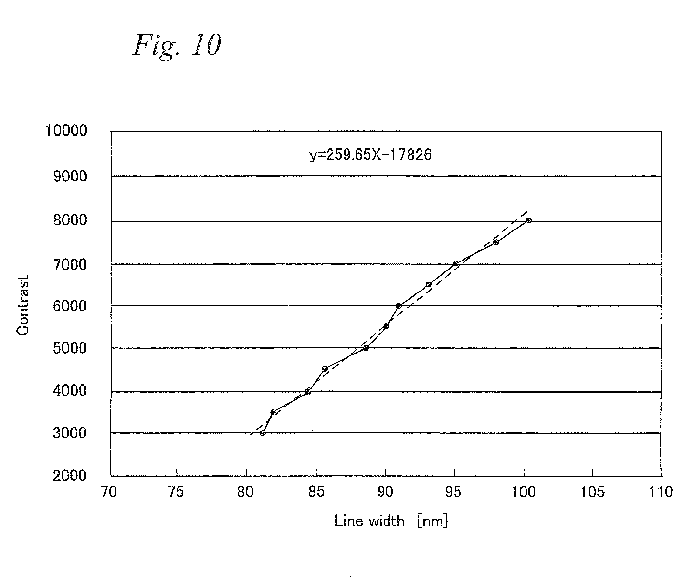

FIG. 10 is a view showing a sequential line graph and an approximate straight line of the sequential line graph, the sequential line graph being obtained by plotting points each having an abscissa that shows an averaged value of linewidths of line patterns of a predetermined measurement mark area in each resist image sent from the SEM and having an ordinate that shows an averaged value of the corresponding contrast values of the measurement mark area, on an orthogonal coordinate system having a horizontal axis showing the linewidths and a vertical axis showing the contrast values, and by connecting adjacent plotted points.
FIG. 11 is a view showing a state where the resist image of the device pattern is formed in shot areas $SA_1$ to $SA_{21}$ of a pilot wafer (or a first wafer) W.
FIGS. 12A and 12B are respectively views used to explain brightness/darkness information of an image of a pattern area (resist image) formed on a wafer related to a modified example, which show the resist image of a measurement pattern and a signal waveform obtained when imaging the resist image with an alignment detection system.

## BEST MODE FOR CARRYING OUT THE INVENTION

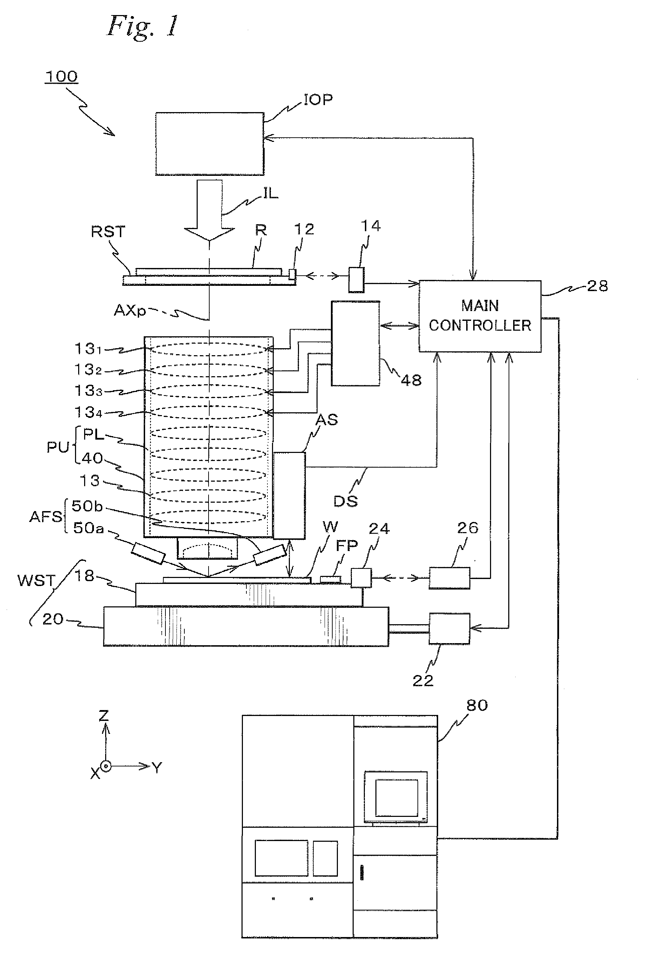

An embodiment of the present invention is described below, referring to FIGS. 1 to 11.

FIG. 1 shows a schematic configuration of an exposure apparatus 100 related to the embodiment. Exposure apparatus 100 is a reduction projection exposure apparatus by a step-and-scan method (a so-called scanning stepper (which is also called a scanner)). In the description below, the explanation is given assuming that a direction parallel to an optical axis AXp of a projection optical system PL (to be described later) is a Z-axis direction, a direction in which a reticle and a wafer are relatively scanned within a plane orthogonal to the Z-axis direction is a Y-axis direction, and a direction that is orthogonal to a Z-axis and a Y-axis is an X-axis direction, and rotation (inclination) directions about an X-axis, the Y-axis and the Z-axis are $\theta x$, $\theta y$ and $\theta z$ directions, respectively.

Exposure apparatus 100 is equipped with an illumination system IOP, a reticle stage RST that holds a reticle R, a projection unit PU that projects an image of a pattern formed on reticle R onto a wafer W which is coated with a photosensitive agent (photoresist), a wafer stage WST that moves within a two-dimensional plane (within the XY plane) while holding wafer W, a drive system 22 that drives wafer stage WST, their control system, and the like.

Illumination system IOP includes a light source that is, for example, composed of an ArF excimer laser (output wavelength: 193nm) (or a KrF excimer laser (output wavelength: 248nm) or the like), an illumination system housing that is connected to the light source via a light-transmitting optical system, and an illumination optical system inside the illumination system housing. As is disclosed in, for example, U.S. Patent Application Publication No. 2003/0025890 and the like, the illumination optical system includes an illuminance uniformity optical system containing an optical integrator or the like, and a reticle blind (none of which are shown), and shapes a laser beam output from the light source and illuminates a slit-shaped illumination area that is elongated in the X-axis direction (the orthogonal direction to the page surface of FIG. 1) on reticle R with substantially uniform illuminance using a laser beam (hereinafter, also referred to as illumination light) IL that has been shaped.

Reticle stage RST is placed below illumination system IOP in FIG. 1. Reticle R is mounted on reticle stage RST and is held by suction via a vacuum chuck or the like (not shown). Reticle stage RST is finely drivable within a horizontal plane (XY plane) and is also scanned in a predetermined stroke range in a scanning direction (in this case, which is to be the Y-axis direction being a lateral direction of the page surface of FIG. 1), with a reticle stage drive system (not shown). The position of reticle stage RST is measured with a laser interferometer 14 arranged externally via a movable mirror (or a mirror-finished end surface) 12, and the measurement values of laser interferometer 14 are supplied to a main controller 28.

Projection unit PU is placed below reticle stage RST in FIG. 1, and includes a barrel 40 and projection optical system PL that is composed of a plurality of optical elements held in a predetermined positional relation within barrel 40. As projection optical system PL, in this case, a both-side telecentric reduction system, which is a dioptric system composed of only a plurality, e.g. around 10 to 20 of dioptric optical elements (lens elements) 13 that are placed along optical axis AXp parallel to the Z-axis direction, is used. Of a plurality of lens elements 13 that constitute projection optical system PL, a plurality (in this case, which is to be four for simplification of the description) of lens elements $13_1$, $13_2$, $13_3$ and $13_4$ on the object plane side (reticle R side) are movable lenses that are drivable from the external by an image-forming characteristic correction controller 48. Lens elements $13_1$ to $13_4$ are held in the barrel respectively via a lens holder having a double structure (not shown). Lens elements $13_1$ to $13_4$ are respectively held by the inner lens holders, and these lens holders are supported by drive elements (actuators, not shown), e.g. piezo elements at three points in the gravity direction with respect to the outer lens holder. And, a configuration is employed in which by adjusting the applied voltage to these drive elements independently, each of lens elements $13_1$ to $13_4$ can be driven and shifted in the Z-axis direction and can be driven (tilted) in inclination directions (i.e. a rotational direction about the X-axis ($\theta x$ direction) and a rotational direction about the Y-axis ($\theta y$ direction)) with respect to the XY plane.

Other lens elements 13 are held by the barrel via a conventional lens holder. Incidentally, not only lens elements $13_1$ to $13_4$, but also lens elements that are placed in the vicinity of a pupil plane or on the image plane side of projection optical system PL, or an aberration correcting plate (optical plate) that corrects aberration of projection optical system PL, especially, a non-rotationally-symmetric component of the aberration, or the like can be configured drivable. Further, the degrees of freedom of the drivable optical elements (directions in which the drivable optical elements can move) are not limited to three, but can be one, two or four or more.

The projection magnification of projection optical system PL is set to one-quarter times as an example. Therefore, as is described earlier, when reticle R is illuminated with uniform illuminance by illumination light IL, a pattern of reticle R within the illumination area is reduced by projection optical system PL and projected on wafer W which is coated with a photoresist, and a reduced image of the pattern is formed on a part of an area to be exposed (shot area) on wafer W. When this operation is performed, projection optical system PL forms the reduced image in a part within its field (i.e. which is an exposure area, and a rectangular area conjugate to the illumination area with respect to projection optical system PL). Incidentally, image-forming characteristic correction controller 48 described earlier moves at least one optical element (such as a lens element) of projection optical system PL in order to adjust the optical characteristics of projection optical system PL, or more specifically, the image-forming state of the pattern image on wafer W, but instead of or in combination with such movement, image-forming characteristic correction controller 48 can also perform, for example, at least one of change in characteristics (e.g. the center wavelength, the spectral width, and the like) of illumination light IL by control of the light source, and movement of wafer W in the Z-axis direction (and inclination of wafer W with respect to the XY plane).

Wafer stage WST includes an XY stage 20 that moves within the XY plane and a wafer table 18 mounted on XY stage 20. On wafer table 18, wafer W is held by, for example, vacuum suction or the like, via a wafer holder (not shown). Wafer table 18 finely drives the wafer holder that holds wafer W in the Z-axis direction and inclination directions with respect to the XY plane and is also called a Z-tilt stage. On the upper surface of wafer table 18, a movable mirror 24 is arranged and a laser beam (measurement beam) from a laser interferometer 26 is irradiated to movable mirror 24, and based on a reflected light from movable mirror 24, positional information of wafer table 18 is measured. In the embodiment, although laser interferometer 26 measures positional information in directions of five degrees of freedom, or more specifically, the positions in the X-axis and Y-axis directions and rotational information in the $\theta x$, $\theta y$ and $\theta z$ directions (pitching, rolling, and yawing), laser interferometer 26 can be capable of also measuring positional information in the Z-axis direction. In this case, a focus sensor AFS (to be described later) is not arranged or can be placed at another position that is different from the exposure position. Incidentally, instead of movable mirror 24, the end surface of wafer table 18 can be mirror-finished to form a reflection surface.

The measurement values of laser interferometer 26 are supplied to main controller 28, and based on the measurement values of laser interferometer 26, main controller 28 controls the position of wafer stage WST, or more specifically, the position of XY stage 20 and wafer table 18 via drive system 22.

Further, the position and inclination quantity in the Z-axis direction of the wafer W surface are measured with focus sensor AFS that is composed of a multipoint focal position detecting system by an oblique incident method having a light-transmitting system 50a and a photodetection system 50b, which is disclosed in, for example, Kokai (Japanese Unexamined Patent Application Publication) No. 06-283403 (the corresponding U.S. Patent No. 5,448,332) and the like. The measurement values of focus sensor AFS are also supplied to main controller 28. Accordingly, the position of wafer table 18 in the Z-axis direction is also controlled.

Further, on wafer table 18, a fiducial plate FP whose surface has the same height as the surface of wafer W is fixed. On the surface of fiducial plate FP, fiducial marks that are used for baseline measurement of an alignment detection system AS (to be described next), and the like are formed.

Alignment detection system AS that detects alignment marks formed on wafer W is arranged separately from projection unit PU described earlier. As alignment detection system AS, as an example, an alignment sensor by an image processing method, which illuminates a mark with a broadband (wideband) light such as a halogen lamp and performs image processing of this mark image, thereby measuring the mark position, is used. This alignment sensor is also referred to a so-called FIA (Field Image alignment) system.

An output signal DS of alignment detections system AS is digitalized via a signal processing system (not shown) and supplied to main controller 28. This operation is further described later.

Moreover, in exposure apparatus 100 of the embodiment, although omitted in the drawings, a pair of alignment systems by a TTR (Through The Reticle) method using a light with an exposure wavelength, which is disclosed in, for example, Kokai (Japanese Unexamined Patent Application Publication) No. 07-176468 (the corresponding U.S. Patent No. 5,646,413) and the like, are arranged as a reticle alignment detection system, and a detection signal of the reticle alignment detection system is supplied to main controller 28.

The control system is mainly configured of main controller 28 in FIG. 1. Main controller 28 is configured of a so-called workstation (or microcomputer) or the like, which is composed of a CPU (Central Processing Unit), an ROM (Read Only Memory), an RAM (Random Access Memory), and the like, and performs overall control of the entire apparatus, besides various control operations described previously.

Incidentally, of the respective constituents described above of exposure apparatus 100, the respective constituent sections except for a part of illumination system IOP including the light source and main controller 28 are housed inside a chamber (not shown), and a coater/developer (not shown, hereinafter referred to as "C/D") is inline connected to the chamber. The C/D includes a coater (resist coating) section that performs coating of a resist to a wafer, a developer (development) section that develops the wafer after exposure, and a coating controller and a development controller, and a resist coating operation and a development operation to a wafer are controlled by the coating controller and the development controller, respectively.

Further, main controller 28 of exposure apparatus 100 is connected to an SEM system 80 that is configured including a measurement SEM that is a kind of a measurement device of a charged-particle beam scanning type, via a communication path. To explain briefly, SEM system 80 is a system that irradiates a measurement pattern with primary beams converged by an electromagnetic field lens within an electron beam barrel where $10^{-5}$ Pa or more is kept, and collects a secondary electron and a reflected electron emitted from the irradiated surface, and detects a measurement pattern edge from the line profile, thereby measuring a pattern size.

SEM system 80 includes, for example: a) an SEM section; b) an SEM control system that integrates a TFE (Thermal Field Emission) high-voltage power supply, a power supply for a converging lens and an objective lens, a deflecting power supply for scanning, a Z sensor control system, and a secondary electron detector; c) a stage control system that controls wafer carriage, and stage drive with a laser interferometer mounted thereon; d)a signal converter that synchronizes a secondary electron signal and a deflection signal and transfers them as image signals; e) an image processing system (including a display device); and f) a main computer that performs overall control of the entire system; and the like.

In the embodiment, the main computer of SEM system 80 is connected to main controller 28 of exposure apparatus 100 via the communication path.

Next, an example of a reticle for measurement used to acquire basic data that is used in measurement of linewidth of patterns is described.

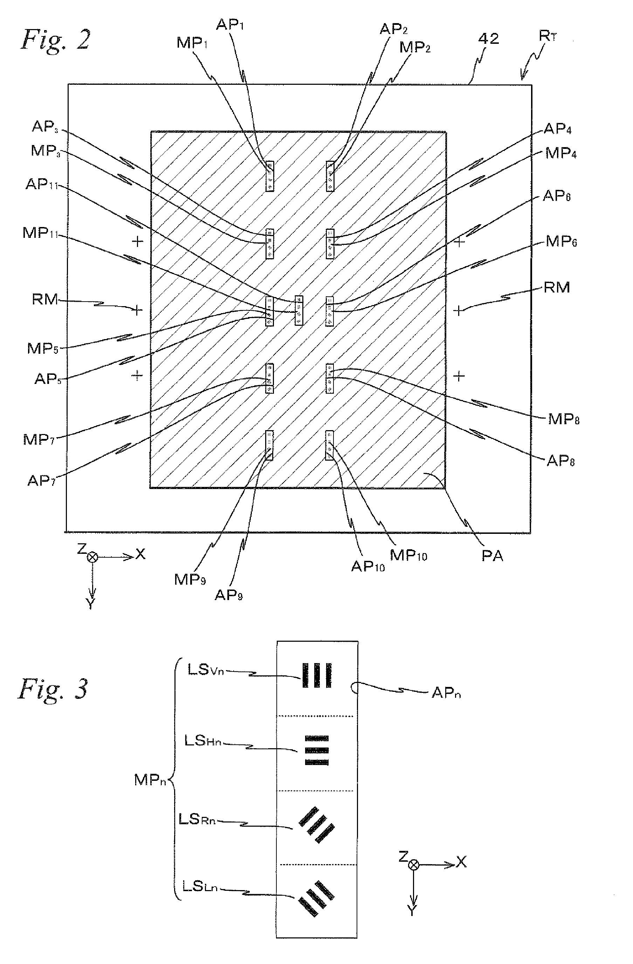

FIG. 2 shows an example of a reticle $R_T$ for measurement. FIG. 2 is a plan view of reticle $R_T$ when viewed from the pattern surface side (the lower surface side in FIG. 1). As shown in FIG. 2, reticle $R_T$ is composed of a glass substrate 42 having a rectangular shape (to be more precise, a square shape), and on its pattern surface, a pattern area PA that is defined by a light-shielding band (not shown) is formed, and in this example, substantially the entire surface of pattern area PA is a light-shielding section by a light-shielding member such as chromium. Pattern area PA has a rectangular shape whose length in the Y-axis direction is longer compared with the length (width) in the X-axis direction, and inside pattern area PA, aperture patterns (transmittance areas) $AP_n$ (n=1, 2, ...... , 11 each having a predetermined width, e.g. $6.075\mu m$ and a predetermined length, e.g. $24.3\mu m$ are formed in the arrangement as shown in FIG. 2, as an example, and in each aperture pattern $AP_n$, a measurement pattern $MP_n$ is respectively formed. As is described later, in the embodiment, eleven aperture patterns $AP_n$ have measurement patterns $MP_n$ whose linewidths (and pitches) are different from one another. In this case, the center of aperture pattern $AP_n$ that is located in the center coincides with the center of pattern area PA (which coincides with the center of reticle $R_T$ (reticle center), in this case).

Each of measurement patterns $MP_n$ includes four types of line-and-space patterns (hereinafter, described as "L/S patterns") $LS_{Vn}$, $LS_{Hn}$, $LS_{Rn}$ and $LS_{Ln}$, as enlargedly shown in FIG. 3. In this case, the periodic directions of L/S patterns $LS_{Vn}$, $LS_{Hn}$, $LS_{Rn}$ and $LS_{Ln}$ are in the X-axis direction, the Y-taxis direction, and a direction angled at +45 degrees with respect to the Y-axis when viewed from a -Z direction, and a direction angled at -45 degrees with respect to the Y-axis, respectively.

Each of L/S patterns $LS_{V11}$, $LS_{H11}$, $LS_{R11}$ and $LS_{L11}$ that constitute measurement pattern $MP_{11}$ located in the center is configured of a multi-line pattern (multi-bar pattern) in which three line patterns each having a predetermined linewidth, e.g. $0.36\mu m$ (360nm) and a predetermined length, e.g. around $2.025\mu m$ are disposed with a predetermined pitch, e.g. $0.72\mu m$ (720nm) in each periodic direction. And, four types of L/S patterns that constitute measurement patterns $MP_1$, $MP_3$, $MP_5$, $MP_7$ and $MP_9$ are configured of multi-line patterns (multi-bar patterns) in which three line patterns each of which has a linewidth of 320nm, 328nm, 336nm, 344nm or 352nm and has a length of around $2.025\mu m$ are disposed with a pitch of 640nm, 656nm, 672nm, 688nm or 704nm, respectively.

Further, four types of L/S patterns that constitute measurement patterns $MP_2$, $MP_4$, $MP_6$, $MP_8$ and $MP_{10}$ are configured of multi-line patterns (multi-bar patterns) in which three line patterns each of which has a linewidth of 368nm, 376nm, 384nm, 392nm or 400nm and has a length of around $2.025\mu m$ are disposed with a pitch of 736nm, 752nm, 768nm, 784nm or 800nm, respectively.

In the embodiment, in a square area ($6.075\mu m$ × $6.075\mu m$) enclosed by solid lines and (a) dotted line (s), which is a quadrisection of aperture pattern $AP_n$, shown in FIG. 3, L/S patterns $LS_{Vn}$, $Ls_{Hn}$, $LS_{Rn}$ and $LS_{Ln}$ whose centers coincide with the centers of the respective square areas are placed, respectively. Incidentally, the boundaries between the square areas shown in dotted lines do not exist actually.

Further, on both sides of pattern area PA in the X-axis direction passing through the reticle center described earlier of the pattern surface of glass substrate 42, a pair of reticle alignment marks RM are formed respectively. And, on one side and the other side of each of the pair of reticle alignment marks RM in the Y-axis direction, reticle alignment marks RM are formed, respectively, at a same distance apart. More specifically, on the pattern surface of glass substrate 42, three pairs of reticle alignment marks RM in total are formed in a symmetric placement with respect to the Y-axis that passes through the reticle center.

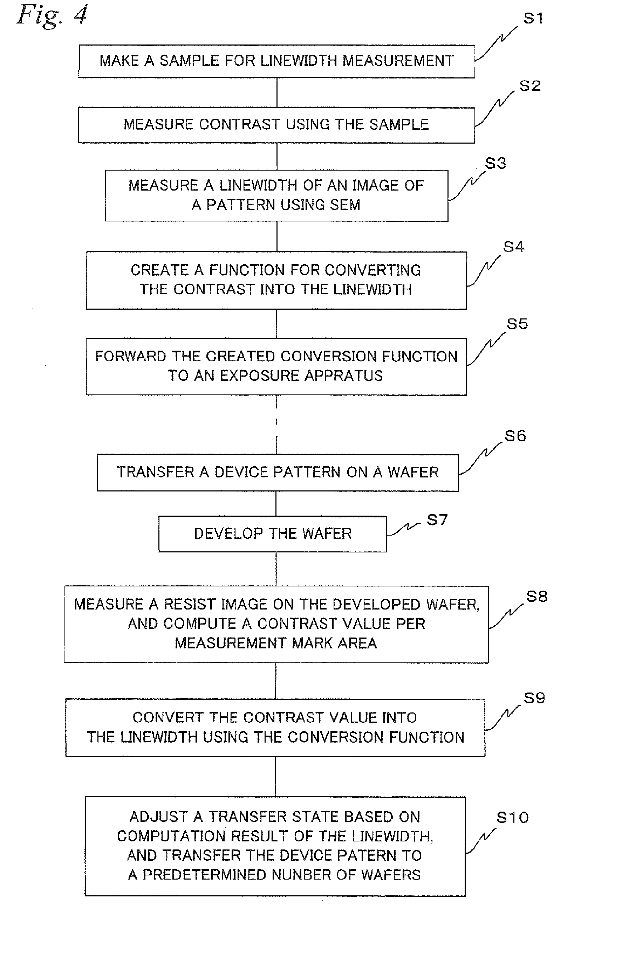

Next, a flow of operations to acquire basic data that is used for measurement of linewidth of patterns and transfer operations of device patterns to a predetermined number of wafers that is performed after the operations to acquire the basic data are described along a flowchart shown in FIG. 4 and also using other drawings as needed.

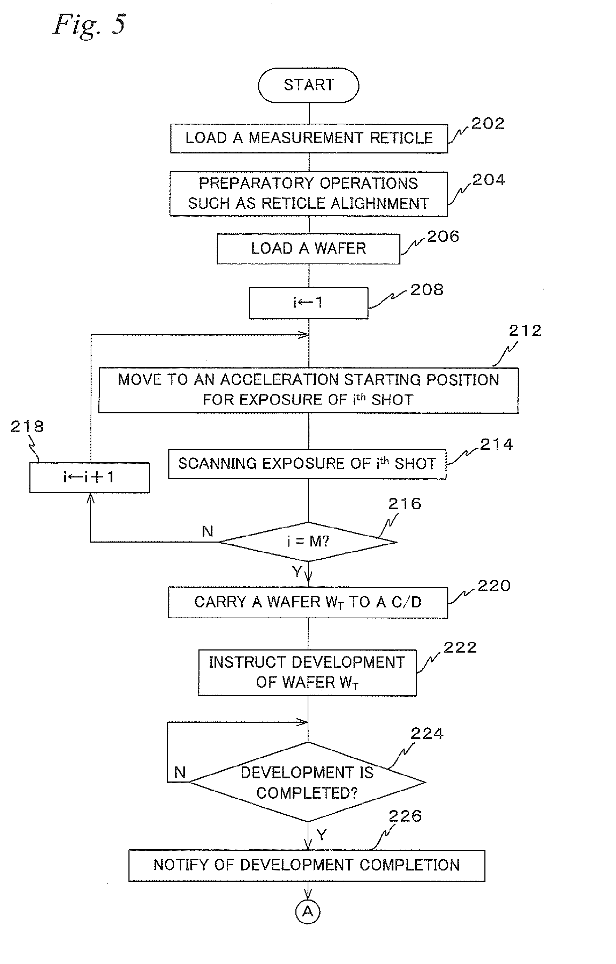

First of all, a sample for linewidth measurement is made (step 1 in FIG. 4). FIG. 5 shows a flowchart corresponding to a processing algorithm of the CPU inside main controller 28 of exposure apparatus 100, which relates to making of the sample for linewidth measurement. It is assumed as a premise of this operation that a reticle is not mounted on reticle stage RST and a wafer is not mounted on wafer stage WST.

First, in step 202 in FIG. 5, the CPU loads reticle $R_T$ described previously on reticle stage RST via a reticle loader (not shown).

Next, in step 204, the CPU performs predetermined preparatory operations such as reticle alignment. Specifically, first, wafer stage WST is moved to a reference position at which the center of a pair of first fiducial marks formed on the surface of fiducial plate FP arranged on wafer table 18 substantially coincides with optical axis AXp of projection optical system PL, and reticle stage RST is moved to a reference position at which the center (reticle center) of a pair of reticle alignment marks located in the center in the Y-axis direction on reticle $R_T$ substantially coincides with the optical axis of projection optical system PL. In this case, the movement of wafer stage WST is performed by main controller 28 controlling drive system 22 while monitoring the measurement values of laser interferometer 26, and the movement of reticle stage RST is performed by main controller 28 controlling a reticle stage drive system (not shown) while monitoring the measurement values of laser interferometer 14. This can also be said for operations in the description below.

Next, a pair of reticle alignment detection systems described earlier perform relative position detection of a pair of first fiducial marks on fiducial plate FP and a pair of reticle alignment marks RM on reticle $R_T$ that correspond to the fiducial marks, using illumination light IL. Next, step movement of reticle stage RST and step movement of wafer stage WST are performed in directions opposite to each other in the Y-axis direction, and the pair of reticle alignment detection systems described above perform relative position detection of another pair of first fiducial marks on fiducial plate FP and another pair of reticle alignment marks RM on reticle $R_T$ that correspond to the fiducial marks, using illumination light IL.

More specifically, as is described above, by measuring the relative positions of at least two pairs of first fiducial marks on fiducial plate FP and the corresponding reticle alignment marks on reticle $R_T$, using the reticle alignment detection systems, while performing step movement of reticle stage RST and wafer stage WST in the Y-axis direction, detection of a positional relation between a coordinate system set by measurement axes of interferometer 26 and a coordinate system set by the measurement axes of interferometer 14, that is, reticle alignment is performed. Incidentally, in this reticle alignment, reticle stage RST can only be moved without moving wafer stage WST.

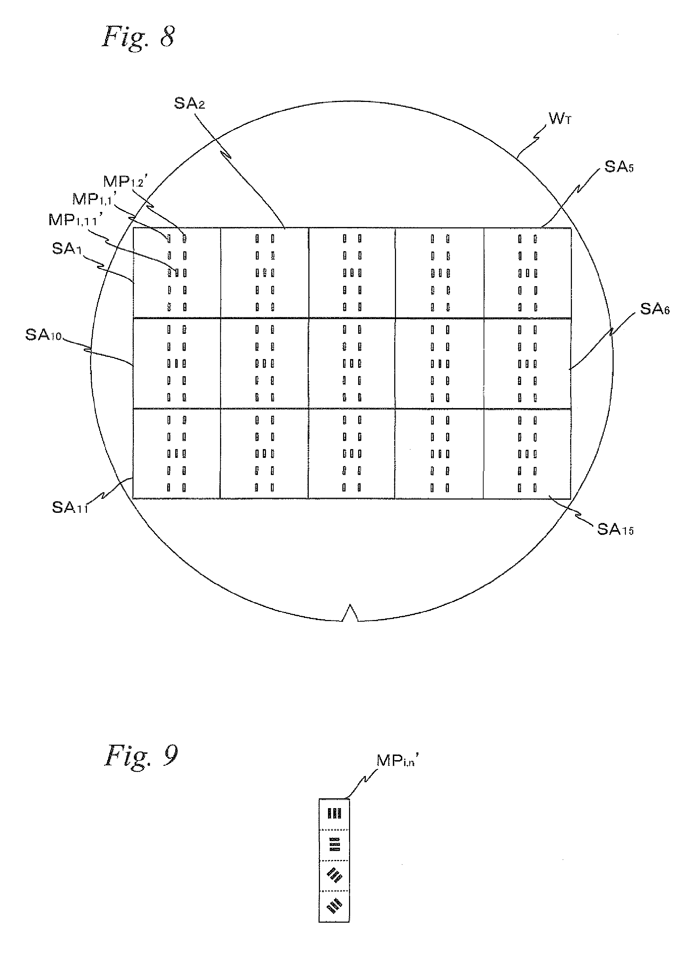

In this manner, when the predetermined preparatory operations are completed, the procedure proceeds to the next step, step 206, in which the CPU loads a wafer for measurement (hereinafter also referred to as "measurement wafer") $W_T$ (refer to FIG. 8) on wafer table 18 from the C/D descried earlier via a wafer loader (not shown). Incidentally, in the embodiment, scanning exposure is performed M times under the same exposure condition using reticle $R_T$, and measurement pattern $MP_n$ is transferred respectively to the M number of shot areas on measurement wafer $W_T$.

In the next step, step 208, the CPU initializes a count value i of a first counter (not shown) that indicates the number of a shot area subject to exposure on measurement wafer $W_T$ to "1" ($i \leftarrow 1$).

In the next step, step 212, the CPU moves wafer stage WST to an acceleration starting position for exposure to an $i^{th}$ (in this case, $1^{st}$) shot area, and also moves reticle stage RST so that the position of reticle $R_T$ is set at an acceleration starting position.

In the next step, step 214, the CPU performs scanning exposure to the $i^{th}$ (in this case, $1^{st}$) shot area that is virtually set on the measurement wafer. Specifically, relative scanning of reticle stage RST and wafer stage WST (XY stage 20) in the Y-axis direction is started. Then, when both the stages achieve the respective target scanning speeds and come into a constant speed synchronous state, pattern area PA of reticle $R_T$ begins to be illuminated with illumination light IL from illumination system IOP, and scanning exposure is started while adjusting the position of wafer table 18 in the Z-axis direction so that the best focus can be realized. Then, different regions of pattern area PA of reticle $R_T$ are sequentially illuminated with illumination light IL and illumination to the entire surface of the pattern area is completed, thereby the scanning exposure is completed. When performing this operation, exposure dose control is performed so that an exposure energy amount (total exposure dose) at one point on measurement wafer $W_T$ becomes the optimal value of the exposure energy amount per process condition that has been obtained in advance by experiments, simulations, or the like and that includes the linewidth of a subject pattern (in this case, at least the linewidth of the line pattern of pattern $MP_{11}$ located in the center among the eleven measurement patterns included in pattern area PA), and the like. With this exposure dose control, pattern area PA formed on reticle $R_T$ is reduced and transferred to the $i^{th}$ (in this case, $1^{st}$) shot area virtually set on measurement wafer $W_T$ via projection optical system PL.

In the next step, step 216, by referring to count value i of the counter described previously, the judgment is made of whether i=M is true or not, or more specifically, whether or not exposure to form the planned M number of transferred images of pattern area PA on measurement wafer $W_T$ is completed. In this case, i=1 is true, or more specifically, the transferred image of pattern area PA (i.e. eleven measurement patterns $MP_n$ (n=1 to 11) in this example) is only formed to a first ($1^{st}$) shot area on measurement wafer $W_T$, and therefore, the negative judgment is made in step 216 and the procedure proceeds to step 218.

In step 218, count value i of the counter described previously is incremented by one ($i \leftarrow i+1$), and the procedure returns to step 212.

After that, until the judgment in step 216 becomes affirmative, the loop process (including the judgment) of steps 212→214→216→218 is repeated.

Then, scanning exposure with appropriate exposure dose is completed to a $M^{th}$ shot area virtually set on measurement wafer $W_T$, and the planned M number (in this case, M=15) of the transferred images of pattern areas PA (eleven measurement pattern $MP_n$ (n=1 to 11)) are formed on measurement wafer $W_T$, the procedure proceeds to step 220. At this point in time, shot areas $SA_1$ to $SA_{15}$ are formed in the arrangement of matrix shape on measurement wafer $W_T$ (refer to FIG. 8).

In this manner, in the embodiment, M times (in this case, M=15) of exposure to sequentially transfer measurement patterns $MP_n$ (n=1 to 11) to the M number of (in this case, M=15) shot areas $SA_1$ to $SA_{15}$ on measurement wafer $W_T$ is to be performed. In the embodiment, a projection area of aperture pattern $AP_n$ by projection optical system PL is referred to a measurement pattern area and a projected image of measurement pattern $MP_n$ is generated within the measurement pattern area.

In step 220, the CPU carries measurement wafer $W_T$ after the exposure process to the C/D that is inline connected to exposure apparatus 100. In this case, measurement wafer $W_T$ is unloaded from wafer table 18 via a wafer unloader (not shown) and carried into the C/D via a wafer carrier system.

In the next step, step 222, the development controller that controls the development section of the C/D is instructed to perform a development process of measurement wafer $W_T$, and then the procedure proceeds to step 224 and waits until development of measurement wafer $W_T$ is completed.

During this waiting time, the development of measurement wafer $W_T$ is performed on the C/D side, and with completion of the development, an image of pattern area PA of reticle $R_T$ is formed in each of shot areas $SA_1$ to $SA_{15}$ on measurement wafer $W_T$ (refer to FIG. 8). In this case, in shot area $SA_1$, images (resist images) $MP_{1,n}'$ (n=1 to 11) of aperture patterns $AP_n$ that includes patterns $MP_n$ for measurement are formed. The same can be said for other shot areas $SA_2$ to $SA_{15}$. FIG. 9 shows an example of a resist image $MP_{i,n}'$ (i=1 to 15) formed inside each shot area $SA_i$. Incidentally, the boundaries, which are indicated in dotted lines in FIG. 9, between areas (hereinafter, referred to as "measurement mark areas" as needed), in which images of the respective L/S patterns are formed, within the measurement pattern area that corresponds to each resist image $MP_{i,n}'$ do not actually exist.

Measurement wafer $W_T$ on which resist images $MP_{i,n}'$ as is described above are formed serves as a sample for measurement of linewidth and contrast.

When confirming that the development of measurement wafer $W_T$ is completed by a notice from the control system of the C/D (not shown) in the waiting state of step 224 described above, the procedure proceeds to step 226, and the CPU display "development completion" on the screen of a display device (not shown), as well as notifying an operator by sounding a buzzer or the like.

In this manner, making of the sample for linewidth measurement in step S1 shown in FIG. 4 is performed.

formed.

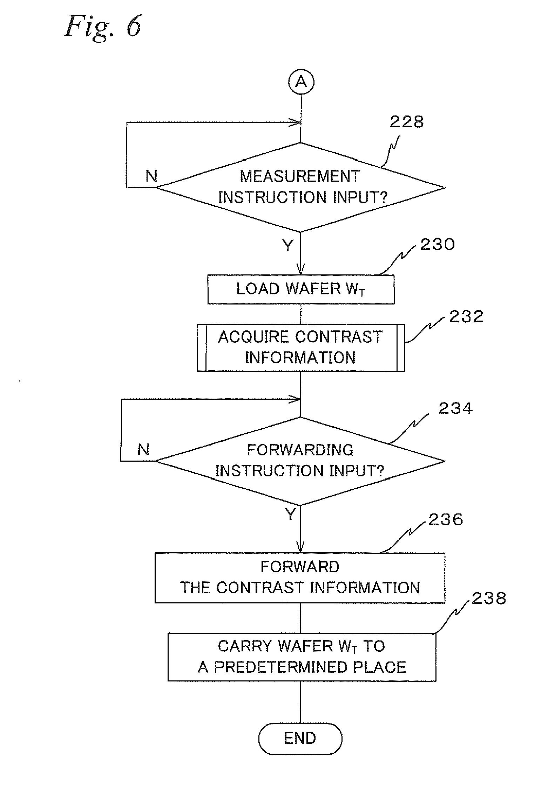

Next, measurement of a contrast value of a pattern image (to be more specific, a contrast value of each measurement mark area described above) is performed using the sample that has been made, that is, measurement wafer $W_T$ (step S2 in FIG. 4). More specifically, detection of each resist image $MP_{i,n}'$ of measurement wafer $W_T$ by alignment detection system AS is performed. FIG. 6 shows a flowchart that corresponds to a processing algorithm of the CPU inside main controller 28 related to this contrast measurement of the pattern image.

After notifying the operator that the development of measurement wafer $W_T$ is completed as described above, the CPU waits for a measurement instruction command to be input, as shown in step 228 in FIG. 6. Then, when the operator inputs the measurement instruction command via an input device (not shown), the judgment in step 228 becomes affirmative, and the procedure proceeds to step 230, and instructions are issued to the wafer loader (not shown) to load measurement wafer $W_T$ on wafer table 18 again similarly to step 206 described earlier, and then the procedure proceeds to a subroutine to acquire contrast information in step 232.

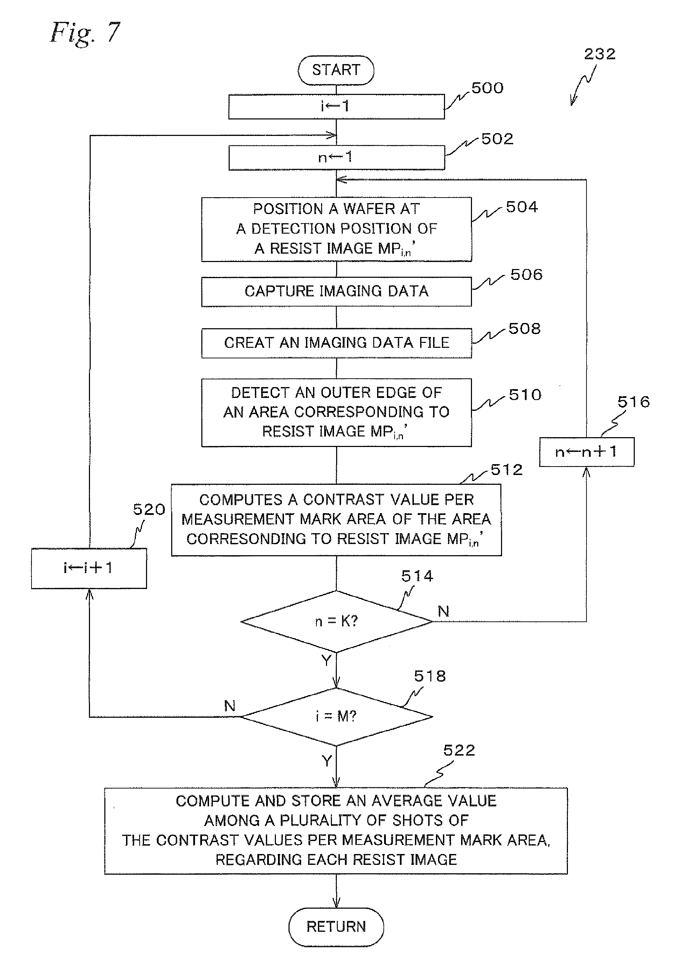

In this subroutine, first of all, in step 500 in FIG. 7, the CPU initializes count value i of the first counter to 1 (i←1). In the next step, step 502, the CPU initializes a count value n of a second counter that indicates the number of a resist image subject to measurement to 1 (n←1).

In the next step, step 504, the CPU moves measurement wafer $W_T$ to a position at which the $n^{th}$ resist image $MP_{i,j}'$ within the $i^{th}$ shot area on measurement wafer $W_T$ can be detected with alignment detection system AS, referring to count value i of the first counter and count value n of the second counter respectively. This movement, or more specifically, position setting is performed by controlling XY stage 20 via drive system 22 while monitoring the measurement values of laser interferometer 26. In this case, the position of measurement wafer $W_T$ is set at a position at which the $1^{st}$ resist image $MP_{1,1}'$ within the $1^{st}$ shot area on measurement wafer $W_T$ can be detected with alignment detection system AS.

In the next step, step 506, the $n^{th}$ resist image $MP_{i,n}'$ (in this case, resist image $MP_{1,1}'$) within the $i^{th}$ shot area on measurement wafer $W_T$ is imaged, and the imaging data is captured. Alignment detection system AS divides the resist image by pixel unit of an imaging device (such as CCD) which alignment detection system AS itself has, and supplies grayscale of the resist image corresponding to each pixel, for example, as 8-bit digital data (pixel data) to main controller 28. More specifically, the imaging data described earlier is composed of a plurality of pixel data. In this case, it is assumed that the deeper (the closer to black) the resist image becomes, the larger the value of the pixel data becomes. Incidentally, in the embodiment, a size of resist image $MP_{i,n}'$ is

1.519μm (in the X-axis direction) × 6.075μm (in the Y-axis direction), and the entirety of the resist image is set within the detection area of alignment detection system AS with enough room, and therefore the entirety of resist image $MP_{i,n}$', that is, the four measurement mark areas can be imaged simultaneously.

In the next step, step 508, the CPU organizes the imaging data of resist image $MP_{i,n}$' (in this case, resist image $MP_{1,1}$') from alignment detection system AS and creates an imaging data file.

In the next step, step 510, the CPU performs image processing of the imaging data to detect the outer edge of a measurement pattern area that corresponds to resist image $MP_{i,n}$' (in this case, resist image $MP_{1,1}$'). In the embodiment, since a positive type resist is used, the measurement pattern area becomes a recessed portion on measurement wafer $W_T$, and four L/S pattern images are formed within this recessed portion. Therefore, the edge of the recessed portion is detected as the outer edge of the measurement pattern area. Incidentally, in the case of enclosing each aperture pattern $AP_n$ with a frame-shaped light-shielding portion on reticle $R_T$, a resist image of the frame-shaped light-shielding portion can be detected as the outer edge described above. Further, the detection of the outer edge can be performed in a method similar to the method that is disclosed in detail, for example, U.S. Patent Application Publication No. 2004/0179190.

In the next step, step 512, the CPU obtains (positional information of) the four measurement mark areas by quadrisecting the outer edge of the measurement pattern area that corresponds to resist image $MP_{i,n}$' (in this case, $MP_{1,1}$') detected as above, that is, the inside of the rectangular frame line, in the Y-axis direction, and computes the contrast value per measurement mark area. In this case, instead of the contrast value per measurement mark area, a contrast value of the measurement pattern area that corresponds to resist image $MP_{i,n}$' can be computed.

In this case, the contrast value per measurement mark area indicates a statistic shown in the formula (1) below, or more specifically, a variance of luminance values of the respective pixels regarding the measurement mark area.

$$C_1 = \frac{\sum_{k=1}^{N}(x_k - x^*)^2}{N-1} \quad \cdots (1)$$

In this case, "$x_k$" denotes a luminance value of a $k^{th}$ pixel inside the measurement mark area, "$x^*$" denotes a predetermined reference value. As the predetermined reference value, in the embodiment, an average value of luminance values of areas, in which there are no images (pattern images for measurement) of patterns $MP_n$ for measurement (to be more specific, L/S patterns

$LS_{Vn}$, $LS_{Hn}$, $LS_{Rn}$, and $LS_{Ln}$) inside the measurement pattern area (or the measurement mark area) that corresponds to at least one resist image on measurement wafer $W_T$, is used. Further, N denotes a total number of pixels inside the measurement mark area.

Incidentally, as the contrast value, a standard deviation of luminance values of the respective pixels regarding the measurement mark area as expressed in the formula (2) below can be used.

$$C_2 = \sqrt{\frac{\sum_{k=1}^{N}(x_k - x^*)^2}{N-1}} \quad \cdots (2)$$

Or, as the contrast value, another statistic that includes a deviation of luminance values of the respective pixels related to each measurement mark with respect to the predetermined reference value described above can also be used.

Incidentally, in step 512, also in the case of computing a contrast value related to an area corresponding to resist image $MP_{i,n}$', the variance, the standard deviation or another statistic of luminance values of the respective pixels similar to the cases described above is used.

More specifically, in step 512, based on the imaging data within the imaging data file described earlier, the contrast value per measurement mark area in the measurement pattern area that corresponds to resist image $MP_{i,n}$' (or the contrast value of the measurement pattern area that corresponds to resist image $MP_{i,n}$') is computed using the above formula (1) or (2). The computation results in this case are stored in a storage device (not shown).

In the next step, step 514, the judgment is made of whether or not a process of all (K number (e.g. K=11)) of resist images within the $i^{th}$ (in this case, $1^{st}$) shot area (whether n=K is true or not), by referring to count value n described earlier. In this case, only the process of the $1^{st}$ resist image $MP_{i,1}$' (resist image $MP_{1,1}$') within the $i^{th}$ (in this case, $1^{st}$) shot area is completed, and therefore the judgment in step 514 is negative, and the procedure proceeds to step 516, in which count value n is incremented by 1 (n←n+1), and then the procedure returns to step 504, and the position of measurement wafer $W_T$ is set at a position at which the $n^{th}$ (in this case, $2^{nd}$) resist image $MP_{i,n}$' (i.e. resist image $MP_{1,2}$') within the $i^{th}$ (in this case, $1^{st}$) shot area on measurement wafer $W_T$ can be detected with alignment detection system AS.

Then, the process from steps 506 to 512 described above is performed again, and similarly to the case of resist image $MP_{1,1}$', the contrast value per measurement mark area in the measurement pattern area that corresponds to resist image $MP_{1,2}$' (or the contrast value of an area that corresponds to resist image $MP_{1,2}$') is obtained and stored in the storage device.

Then, in step 514, the CPU judges whether the process of K number (e.g. K=11) of resist images within the $i^{th}$ (in this case, $1^{st}$) shot area by referring to count value n, but the judgment in this case is negative. After that, until the judgment in step 514 becomes affirmative, the process (including the judgment) of steps 502 to 516 described above is repeated. Accordingly, regarding other resist images $MP_{1,3}'$, $MP_{1,4}'$, $MP_{1,5}'$, $MP_{1,6}'$, $MP_{1,7}'$, $MP_{1,8}'$, $MP_{1,9}'$, $MP_{1,10}'$ and $MP_{1,11}'$, the contrast value per measurement mark area in an area that corresponds to each resist image (or the contrast value of an area that correspond to the resist image) is obtained similar to the case of resist image $MP_{1,1}'$, descried earlier.

In this manner, when computation and storage processes of the contrast related to all the resist images within the $i^{th}$ (in this case, $1^{st}$) shot area on measurement wafer $W_T$ are performed, the judgment in step 514 becomes affirmative, and the procedure proceeds to step 518, in which the judgment is made of whether or not the process of all the shot areas on measurement wafer $W_T$ is completed by referring to count value i of the first counter. In this case, since i=1 is true, the negative judgment is made here, and the procedure proceeds to step 520, in which count value i is incremented by 1 (i←i+1), and then the procedure returns to step 502, and count value n is initialized to 1 (n←1).

Then, the loop process (including the judgment) in steps 504 to 516 is repeated until the judgment in step 514 becomes affirmative. Accordingly, the computation and storage processes of the contrast of K number (in this case, 11) of resist images $MP_{2,1}'$ to $MP_{2,11}'$ within the $i^{th}$ (in this case, $2^{nd}$) shot area $SA_2$ on measurement wafer $W_T$ is performed respectively.

And, when the foregoing computation and storage of the contrast value of $K^{th}$ (in this case, $11^{th}$) resist image $MP_{2,11}'$ within shot area $SA_2$ are completed, the procedure proceeds to step 518, in which the judgment is made of whether or not the process of all the shot areas on measurement wafer $W_T$ is completed, by referring to count value i of the first counter. In this case, since i=2 is true, the negative judgment is made here, and the procedure proceeds to step 502, and after count value i is incremented by 1 (i←i+1), the procedure returns to step 502.

Afterwards, until the judgment is step 518 becomes affirmative, the process of step 502 and the succeeding steps (including the judgment) is repeated.

Accordingly, the contrast measurement and storage of eleven resist images are performed with respect to each of the $3^{rd}$ to $15^{th}$ shot areas.

Then, when the contrast computation and storage of the $11^{th}$ resist image of the $15^{th}$ shot area $SA_{15}$ are completed, the judgment in step 518 becomes affirmative, and the procedure proceeds to step 522.

In step 522, with respect to each resist image, an average value of the contrast values per measurement mark area among a plurality of shot areas is computed and stored. To be specific, an averaged value of the contrast values per measurement mark area in an area that corresponds to each resist image $MP_{i,1}'$ is obtained regarding resist images $MP_{i,1}'$ (i=1 to 11) (the average value of a plurality of shot areas, e.g. shot areas $SA_1$ to $SA_{15}$), and stored in the storage device. Similarly, also regarding resist image $MP_{i,2}'$ (i=1 to 11), resist image $MP_{i,3}'$ (i=1 to 11), resist image $MP_{i,4}'$ (i=1 to 11), resist image $MP_{i,5}'$ (i=1 to 11), resist image $MP_{i,6}'$ (i=1 to 11), resist image $MP_{i,7}'$ (i=1 to 11), resist image $MP_{i,8}'$ (i=1 to 11), resist image $MP_{i,9}'$ (i=1 to 11), resist image $MP_{i,10}'$ (i=1 to 11), and resist image $MP_{i,11}'$ (i=1 to 11), the averaged value of the contrast values per measurement mark area in an area that corresponds to each resist image is obtained and stored in the storage device.

Then, the process of subroutine 232 is completed, and the procedure returns to step 234 shown in FIG. 6. In step 234, the CPU waits for a forwarding instruction, and when the forwarding instruction is input by the operator via the input device, in step 236 the CPU forwards the contrast information obtained as described above to a computer (not shown) that is connected to exposure apparatus 100, via a communication path (not shown, e.g. LAN or the like).

In the next step, step 238, the CPU carries measurement wafer $W_T$ to a predetermined place near SEM system 80, and completes a series of processes of this routine. In this case, the predetermined place means a place set in advance from which the operator can take out measurement wafer $W_T$ without difficulty and which is good for carrying measurement wafer $W_T$ that has been taken out into a wafer carrier system on the atmospheric side of SEM system 80.

With this operation, the process in step S2 shown in FIG. 4 is completed.

Next, the linewidth of the pattern image (resist image) is measured with SEM system 80 (step S3 in FIG. 4). This linewidth measurement is performed in the following procedure.

The operator takes out measurement wafer $W_T$ that has been developed from the predetermined place described above and carries measurement wafer $W_T$ to the wafer carrier system of SEM system 80.

After that, according to instructions of the operator, the linewidth measurement of each L/S pattern in the resist image is performed using measurement wafer $W_T$ as a sample, in the procedure similar to the conventional case.

In this case, according to instructions of the operator, measurement wafer $W_T$ is moved within SEM system 80 by the carrier system and is carried into a sample chamber via a load lock chamber.

Next, according to instructions of the operator, images (SEM images) of all resist images $MP_{i,n}'$ within all shot areas $SA_1$ to $SA_{15}$ on measurement wafer $W_T$ are captured, respectively, with SEM system 80.

Next, by an image processing system of SEM system 80, the image processing accompanying the edge detection processing is respectively applied to each of the images of all resist images $MP_{i,n}'$ within all shot areas $SA_1$ to $SA_{15}$ on measurement wafer $W_T$ that have been captured. With this processing, the linewidth of the line pattern per measurement mark area of each resist image $MP_{i,n}'$ is respectively measured, and the measurement results are stored in an internal memory of the main computer of SEM system 80, and also displayed on the screen of the display device.

After that, the operator views the display screen showing measurement results obtained by SEM system 80, and instructs the main computer of SEM system 80 to perform necessary computation processing, for example, computation of averaged value (the average value of a plurality of shot areas, e.g. shot areas $SA_1$ to $SA_{15}$) of linewidths of line patterns per measurement mark area of each resist image.

In response to the instructions of the operator, the main computer of SEM system 80 computes the averaged value of linewidths of the line patterns per measurement mark area in each resist image, and the computation results are displayed on the screen of the display device. When the computation results are displayed, the operator views the display screen, and instructs the main computer of SEM system 80 to transmit information of the computation results to the computer described earlier. Accordingly, the information of the computation results is sent from the main computer of SEM system 80 to the computer, and the computer receives the information of the computation results and stores the information in the memory.

In this manner, the linewidth measurement of images of the patterns in step S3 is completed.

Next, a function to convert the contrast value of the resist image into the linewidth (the linewidth measured with SEM system 80) is created (step S4 shown in FIG. 4). Creation of the function is performed as described below.

The operator (or a worker) instructs the computer described previously to create a sequential line graph as shown in FIG. 10. The sequential line graph shown in FIG. 10 is created by plotting points each having an abscissa that shows an averaged value of linewidths of the line patterns of a predetermined measurement mark area in the resist image (e.g. the resist image of line patterns of $LS_{Vn}$) that has been sent from SEM system 80 and having an ordinate that shows an averaged value of the corresponding contrast values of the measurement mark area, on an orthogonal coordinate system having a lateral axis showing the linewidths and a vertical axis showing the contrast values, and by connecting the adjacent plotted points.

Next, when confirming that the sequential line graph is displayed on the display, the operator instructs the computer to compute an approximate curve of the sequential line graph. In response to this instruction, for example, an approximate curve (an approximate straight line, in this case) $y=259.65x-17826$ as shown in a broken line in FIG. 9 is computed.

Next, the operator instructs the computer to convert the approximate curve (the approximate straight line, in this case) into a function with "y" (the contrast value described earlier) serving as an independent variable and "x" (the linewidth described earlier) serving as a dependent variable.

Accordingly, the computer computes a conversion function as expressed in the formula (3) below (a function that converts the contrast value described earlier into the linewidth measured by the SEM), displays the conversion function on the display, and stores it in a memory.

$$x = \frac{1}{259.65}(y + 17826) \quad \cdots(3)$$

After that, in the similar procedures, in response to instructions of the operator, the computer obtains the function that converts the contrast value into the linewidth measured by the SEM and stores it in the memory, with respect to other measurement mark areas (L/S patterns $LS_{Hn}$, $LS_{Rn}$, and $LS_{Ln}$).

As is described above, the creation of the functions in step S4 shown in FIG. 4 is completed.

Next, the created conversion functions are forwarded to the exposure apparatus (step S5 in FIG. 4). More specifically, the operator instructs the computer to forward the functions (conversion functions) created as above to main controller 28 of exposure apparatus 100. With this instruction, the functions serving as conversion information are sent from the computer to main controller 28, and stored in a predetermined region in the storage device. Afterwards, main controller 28 can convert the contrast value of the resist image of the line pattern into the linewidth using these functions. Incidentally, in the embodiment, the operator intervenes when the conversion information described above is determined, but at least a part of the operation of the operator can be automated by software. Further, the foregoing operation can be controlled by a host computer that performs overall control of many manufacturing apparatuses that include the exposure apparatus.

In the embodiment, after the process of step S5 described above is completed, transfer of device patterns to a predetermined number of wafers is performed in the following procedure.

First of all, in response to instructions of the operator, exposure apparatus 100 transfers device patterns formed on reticle R respectively to a plurality of shot areas on a pilot wafer (or a first wafer) W via projection optical system PL in a step-and-scan method (step S6 in FIG. 4), after preparatory operations such as reticle alignment and baseline measurement of alignment detection system AS. Incidentally, since such a series of operations are similar to those of a conventional scanner, detailed description is omitted. Further, in the embodiment, although reticle R for device manufacturing is used, a measurement reticle having a pattern whose linewidth is at least the same as the linewidth of the pattern of reticle R can be used. Incidentally, the pilot wafer is a wafer that is used in test exposure to obtain exposure conditions of the wafer and/or performances of the exposure apparatus prior to forming the device patterns on the wafers for device manufacturing within a lot.

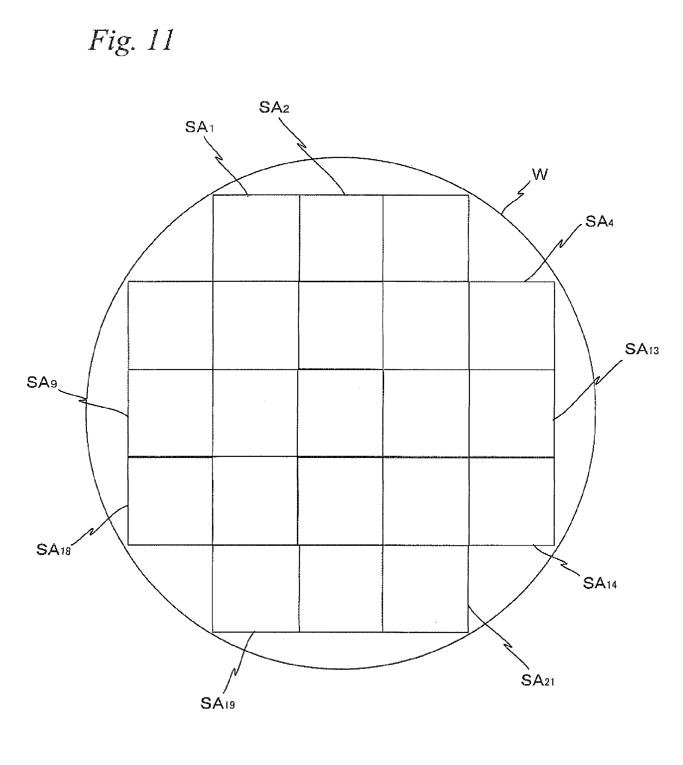

Next, the pilot wafer (or the first wafer) W after the exposure process is carried from exposure apparatus 100 to the C/D, and the C/D develops the pilot wafer (or the first wafer) W (step S7 in FIG. 4). With this development, resist images of the device patterns are formed in shot areas $SA_1$ to $SA_{21}$ on the pilot wafer (or the first wafer) W (refer to FIG. 11).

Next, the pilot wafer (or the first wafer) W after the development is loaded again on wafer table 18 of exposure apparatus 100, and alignment detection system AS sequentially measures contrast values of the resist images such as L/S patterns included in the device patterns within shot areas $SA_1$ to $SA_2$, on the pilot wafer (or the first wafer) W, in the manner similar to the manner described above (step S8 in FIG. 4).

Next, main controller 28 of exposure apparatus 100 converts the contrast value of the resist image of each L/S pattern or the like that has been measured, into the linewidth of the line pattern included in the resist images of each L/S pattern or the like, using the conversion function (step S9 in FIG. 4).

Next, main controller 28 transfers the device patterns on reticle R to a predetermined number of wafers, respectively, in a transfer state that has been adjusted or while adjusting the transfer state, based on the computation results (conversion results) of the linewidths of the line patterns included in the resist images of each L/S pattern or the like (step S10 in FIG. 4). In this case, main controller 28 can transfer the device patterns on reticle R onto the wafers, after or while adjusting optical characteristics (including the image-forming characteristic) of projection optical system PL, e.g. at least one of magnification, distortion, comma and field curvature, by driving at least one of lens elements $13_1$, $13_2$, $13_3$, and $13_4$ with image-forming characteristic correction controller 48, based on the computation results (conversion results) of the linewidths of the line patterns. Or, main controller 28 can transfer the device patterns on reticle R onto the wafers, after or while adjusting the total energy amount of the exposure light irradiated to the wafers based on the computation results (conversion results) of the linewidths of the line patterns. Or, main controller 28 can transfer the device patterns on reticle R onto the wafers, while adjusting a synchronous state of reticle R (reticle stage RST) and wafer W (wafer stage WST (XY stage 20 and wafer table 18) based on the computation results (conversion results) of the linewidths of the line patterns. The point is that a forming state of transferred images of the device patterns formed by scanning exposure should be adjusted by adjusting a part of exposure apparatus 100 during the scanning exposure or prior to the scanning exposure, based on the computation results (conversion results) of the linewidths of the line patterns.

As is described above, according to the embodiment, exposure by a step-and-scan method is executed by exposure apparatus 100 and the device patterns (patterns that include a plurality of line patterns with a predetermined spacing therebetween) of reticle R are transferred to a plurality of shot areas $SA_1$ to $SA_{21}$ on wafer W, respectively. On this operation, when performing scanning exposure, wafer W is exposed with illumination light IL via projection optical system PL, the images of the device patterns are formed in each shot area on wafer W (step S6 in FIG. 4), wafer W after the exposure is developed (step S7), and the resist images of the device patterns are formed in each of a plurality of shot areas $SA_1$ to $SA_{21}$ on wafer W.

Then, the resist image of the device pattern formed in each of a plurality of shot areas $SA_1$ to $SA_{21}$ on wafer W is measured by exposure apparatus 100 (step S8 in FIG. 4). More specifically, a measurement area (a pattern area) that includes a part of the resist image of the device pattern whose linewidth should be measured is imaged for each shot area by alignment detection system AS, and the contrast value of the image of the pattern area is computed by main controller 28 of exposure apparatus 100 based on the imaging results. Next, the computed contrast value is converted into the linewidth of the line pattern by main controller 28 of exposure apparatus 100, based on known conversion information (conversion function) (step S9 in FIG. 4). Therefore, even if the pattern area described above is imaged using a microscope having a low resolving power, e.g. an image-forming type alignment sensor such as alignment detection system AS of exposure apparatus 100 or the like, without using the SEM or the like, the linewidth of the line pattern can be measured with high precision. Accordingly, the linewidth measurement with low cost and high throughput can be performed. Incidentally, although the linewidth measurement of the resist image is performed in all of shot areas $SA_1$ and $SA_{21}$ of wafer W in step S8 shown in FIG. 4, the number of shot areas of which the linewidth measurement is performed can be one, or a plural number that is different from the number of shot areas on wafer W.

Further, according to the embodiment, since the forming state of the image of the device pattern is detected based on results of the linewidth measurement described above, the forming state of the image of the pattern can be detected with high precision in a short period of time, in a state where the running cost is kept down.

Further, according to the embodiment, exposure apparatus 100 detects the forming state of the image of the device pattern formed in each of a plurality of shot areas $SA_1$ to $SA_{21}$ on wafer W with high precision in a short period of time, in a state where the running cost is kept down, and based on the detection results, the forming state of the image of the device pattern during exposure is adjusted (S10 in FIG. 4). Accordingly, high-precision generation of the pattern image on wafer W, that is, high-precision exposure is realized. In this case, in order to adjust the forming state of the image of the device pattern, the optical characteristics (including the image-forming characteristics) of projection optical system PL can be adjusted based on the detection results of the forming state of the image of the pattern described above. In such a case, high-precision adjustment of the projection optical system with low cost in a short period of time can be performed. Or, in order to adjust the forming state of the image of the device pattern, the total energy amount of the exposure light irradiated to the wafer can be adjusted, or the synchronous state between reticle stage RST, and XY stage 20 and wafer table 18 can be adjusted.

Incidentally, in the embodiment, the forming state of the image of the device pattern during exposure can be adjusted in the various methods described above, based on the results of the forgoing linewidth measurement. In such a case as well, high-precision generation of the pattern image on wafer W, that is, high-precision exposure is realized.

Further, in the embodiment, although adjustment of the optical characteristics of projection optical system PL is performed based on the results of the linewidth measurement described above, exposure conditions (e.g. including an illumination condition, an exposure dose, or adjustment information of the exposure apparatus descried earlier) used to form the device pattern of reticle R on wafer W can only be determined. Furthermore, based on the results of the linewidth measurement described above, processing conditions (e.g. a coating condition, or a development condition) of wafer W by the C/D can be determined. In this case, both the processing conditions of the C/D and the exposure conditions of the exposure apparatus can also be determined. Further, in the embodiment, the exposure conditions of the wafer by the exposure apparatus and the processing conditions of the wafer by the C/D (including a type, a film thickness of a resist, and the like) are the same in the process of acquiring the conversion information described above and the process of measuring the pattern linewidth described above (i.e. the process of forming the device pattern described above), but at least a part of the exposure conditions and the processing conditions (hereinafter, collectively referred to as substrate processing conditions) can be different. However, in the case where the substrate processing conditions in the linewidth measuring process (pattern forming process) are changed, and the accurate linewidth measurement cannot be performed with conversion information that has been acquired under the substrate processing conditions before the change, the conversion information described above can be acquired under the substrate processing conditions after the change. That is, the conversion information described above can be acquired under the different substrate processing conditions, respectively.

Incidentally, in the embodiment above, the explanation is employed as if a series of procedures (steps S1 to S5) to create the conversion functions are performed just before step S6 described above (refer to FIG. 4), but the series of procedures to create the conversion functions as explained in steps S1 to S5 above can be performed at any time as long as the series of procedures are performed prior to actual transfer of the device patterns. Further, in the embodiment above, the case has been described where a resist image of the pattern for measurement on measurement wafer $W_T$ is imaged using alignment detection system AS of exposure apparatus 100 as the first measurement device, in order to obtain the contrast value of the image of the pattern for measurement, but the this is not intended to be limiting, a resist image of the pattern for measurement on measurement wafer $W_T$ can be imaged using another imaging device. For example, an overlay measuring device that is different from the exposure apparatus can be used as the first measurement device. Further, the photodetection element of the first measurement device is not limited to the CCD but can be a line sensor, and the method is not limited to the image processing method (imaging method) but can be other methods. Incidentally, as is described earlier, the first measurement device may be a measurement device having a low resolving power (or a resolution lower than the linewidth of a pattern subject to measurement) that cannot measure the linewidth of the pattern. Further, in the embodiment above, the SEM is used as the second measurement device that is different from the first measurement device in order to acquire the conversion information described above, but the second measurement device is not limited to the SEM, and only has to be a measurement device having a high resolving power (or a resolution that is the same as or higher than the linewidth of a pattern subject to measurement) that can measure the linewidth of the pattern.

Further, in the embodiment above, for example, the subject of the imaging that is performed as a part of the series of procedures to crease the conversion functions can be a latent image that is formed on a resist during exposure, or can be an image (an etching image) that is obtained by developing a wafer on which the image is formed and performing etching processing of the wafer. Further, a photosensitive layer on which an image is formed on an object such as a wafer is not limited to a photoresist, but only has to be a layer on which an image (a latent image and a visualized image) is formed by irradiation of a light (energy), and for example, can be an optical recording layer, or an magnetooptical recoding layer.

The point is that the arrangement should be made where brightness/darkness information (such as the contrast value) of an image of a pattern area that has been measured with respect to a pilot wafer or a wafer at the head of a lot can be converted into the linewidth of the line pattern, when consecutively transferring the device patterns of reticle R to a plurality of wafers. In this case, the images in different states (e.g. a resist image and a latent image) can be detected in the acquisition process of the conversion information and the measurement process of linewidth, but it is preferable to detect the images in the same state in both the processes.

Incidentally, in the embodiment above, although the case has been described where four types of L/S patterns (multi-bar patterns) placed within aperture pattern $AP_n$ are used as measurement pattern $MP_n$ on reticle $R_T$, but this is not intended to be limiting, and the measurement pattern can include only one pattern or one type of patterns, or an isolated pattern such as an isolated line can be used instead of or in combination with a dense pattern such as the L/S pattern. Further, in the embodiment above, the K number of measurement patterns $MP_n$ whose linewidths are different are placed spaced apart from one another on reticle $R_T$ as in FIG. 2, but for example, the K number of measurement patterns $MP_n$ can be placed in proximity to substantially the same position on reticle $R_T$. In this case, the K number of measurement patterns $MP_n$ are regarded as a pattern group, and the pattern group can be formed at different positions respectively on reticle $R_T$. Further, the K number of measurement patterns $MP_n$ can be formed in a part of the pattern area of reticle $R_T$ so that the K number of measurement patterns $MP_n$ are simultaneously placed within the illumination area described earlier.

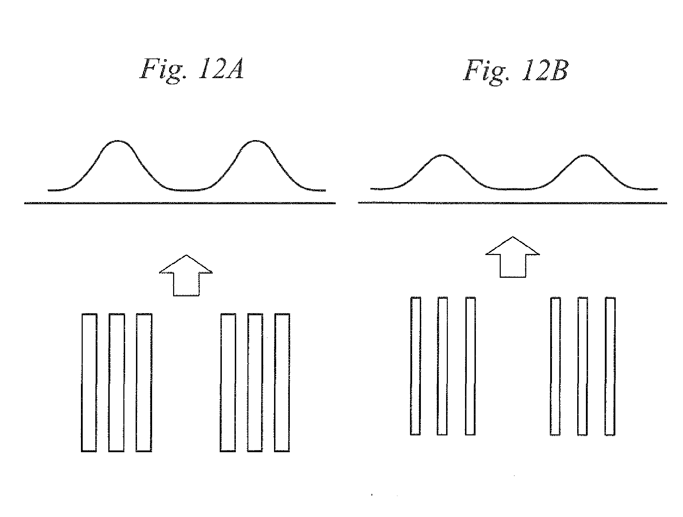

Further, in the embodiment above, the contrast value per measurement mark area (or measurement pattern area), which is computed using the variance or the standard deviation of the luminance values per measurement mark area (or measurement pattern area) of image (resist image) $MP_{i,n}$' (refer to FIG. 9) of aperture pattern $AP_n$ that includes measurement pattern $MP_n$ for measurement inside as shown in FIG. 3, or another statistic that includes the deviation of the luminance values of the respective pixels with respect to the predetermined reference value described above, is used as brightness/darkness information, but the present invention is not limited thereto. For example, a resist image of a pattern, in which at least two sets of a plurality (e.g. three) of line patterns (multiline pattern) as shown in the lower side of FIGS. 12A and 12B are placed at a predetermined distance (e.g. a width that is substantially the same as the width of an area in which the multiline pattern is located), is formed on a wafer, and this resist image is imaged with alignment detection system AS of the exposure apparatus, and from the imaging data, a ratio of the average value of luminance values of pixels in the area where at least one multiline pattern is located, to the average value of luminance values of pixels in a space area where there is no pattern between the multiline patterns is obtained, and the ratio can be used as brightness/darkness information per measurement mark area (or measurement pattern area). In such a case, as is obvious when comparing FIG. 12A and FIG. 12B, a mark waveform that is obtained by the imaging by alignment detection system AS shows a waveform that is in accordance with the linewidth of each line pattern that constitutes the multiline pattern (or a duty ratio between a line section and a space section in the area where the multiline pattern is located). However, each multiline pattern in this case is a pattern having a linewidth finer than a resolution limit of alignment detection system AS.

As is obvious from the above description, it is sufficiently possible to use the above-described ratio as a representative value of brightness/darkness information per measurement mark area (or measurement pattern area), and a conversion function (a function that converts the ratio described above into a linewidth measured by the SEM) can be obtained in a method similar to the one in the embodiment above, even if the ratio is used instead of the contrast value described earlier. In this case as well, even if a resist image of an area formed on a wafer at the head of a lot or a pilot wafer, which includes a pattern in which at least a pair of the above-described multiline patterns are placed spaced apart at a predetermined distance (e.g. a width that is substantially the same as the width of the area where the multiline pattern is located), is imaged, without using the SEM but using a microscope having a lower resolving power, e.g. alignment detection system AS of exposure apparatus 100 or the like, the linewidth of the line pattern can be measured with high precision. Consequently, the linewidth measurement with low cost and high throughput can be performed.

Incidentally, in the embodiment above, in the case of using the statistics shown in the formulas (1) and (2) described earlier as the contrast value of the measurement mark area (or the area corresponding to the resist image), the predetermined reference value is not limited to the average value of luminance values of the area where there is no pattern image for measurement, but can be a luminance value of an arbitrary pixel within the area. Further, in the example explained using FIGS. 12A and 12B, the ratio of the average value of luminance values of the area where at least one multiline pattern is located, to the average value of luminance values of the pixels in the space area is used as brightness/darkness information per measurement mark area (or measurement pattern area). However, this is not intended to be limiting, and the difference between both the average values can be used as brightness/darkness information per measurement mark area (or measurement pattern area), or the ratio or the difference between the total sum of luminance values of a predetermined number of pixels in the area where the multiline pattern is located and the total sum of luminance values of pixels in the space area can be used as the brightness/darkness information. Incidentally, in this specification, a term "luminance value" is used as a concept of wide range that includes not only the luminance (a unit is $[cd/m^2]$) in the ordinary sense but also the mere intensity (such as the light intensity).

Further, in the embodiment above, the case has been exemplified where the conversion functions described earlier are used as conversion information that converts the brightness/darkness information into the linewidth, but the present invention is not limited thereto as a matter of course. More specifically, the conversion information is not limited to the conversion functions (conversion formulas) but can be mere data in table format, or the like.

Further, in the embodiment above, the case has been described where during exposure of wafer $W_T$ for measurement, a stepping distance between shots of wafer stage WST is set similar to the distance at the time of device manufacturing, and the exposure in a step-and-scan method is performed, but this is not intended to be limiting, and it is also possible that the stepping distance between shots of wafer stage WST is set slightly shorter than the width (the length in the X-axis direction) of resist image $MP_{i,n}'$ formed on measurement wafer $W_T$, and the exposure in the step-and-scan method is performed. By doing so, a rectangular area in which resist images $MP_{i,n}'$ are placed in a row matrix shape without spacing (partially overlapping) in the X-axis direction is formed at eleven positions on wafer $W_T$ for measurement, and therefore it becomes possible to perform the imaging with alignment detection system AS of each rectangular area, which allows the measurement time to be shortened. Incidentally, the stepping distance between shots of wafer stage WST is set slightly shorter than the width (the length in the X-axis direction) of resist image $MP_{i,n}'$ formed on measurement wafer $W_T$, in order to prevent the boundary lines between adjacent resist images $MP_{i,n}'$, which become an error factor during contrast computation of each resist image, from being left. In this case, the outer edge of each rectangular area is detected in a similar method to the method disclosed in detail in U.S. Patent Application Publication No. 2004/179190, and after positional information of each resist image $MP_{i,n}'$ or positional information of each measurement mark area that constitutes each resist image $MP_{i,n}'$ is computed by performing a predetermined computation based on the detection results, the contrast value of the image of each resist image $MP_{i,n}'$ or each measurement mark area that constitutes each resist image $MP_{i,n}'$ is computed.

Incidentally, in the embodiment above, measurement pattern $MP_n$ is to be transferred onto measurement wafer $W_T$ by scanning exposure, but static exposure can be used instead of the scanning exposure. In this case, reticle $R_T$ shown in FIG. 2 may be step-moved in the Y-axis direction relative to the illumination area, which is illuminated with illumination light IL, within the field of projection optical system PL, but it is desirable to use a measurement reticle on which patterns for measurement are distributed in an area corresponding to the illumination area. In such a case, by using conversion information obtained in the procedures similar to the above-described procedures, without being affected by the synchronous error between the reticle stage and the wafer stage, it becomes possible to detect the linewidth of the pattern, and hence to detect a forming state of an image of the pattern, and to adjust the optical characteristics of projection optical system PL based on the detection results.

Further, the magnification of the projection optical system of the exposure apparatus in the embodiment above is not limited to the reduction system but can be either an equal magnifying system or a magnifying system, and projection optical system PL is not limited to a dioptric system, but can be either a catoptric system or a catadioptric system, and the projected image can be either an inverted image or an upright image.

Further, in the embodiment above, illumination light IL is not limited to the ArF excimer laser light (wavelength: 193nm) or the KrF excimer laser light (wavelength: 248nm), but can be an $F_2$ laser light (wavelength: 157nm) or the like. Further, illumination light IL is not limited to the light having a wavelength more than or equal to 100nm, and it is needless to say that the light having a wavelength less than 100nm can be used. For example, the linewidth measuring method, the image-forming-state detecting method, the adjustment method, and the exposure method of the present invention can also be applied to an EUV (Extreme Ultraviolet) exposure apparatus that makes an SOR or a plasma laser as a light source generate an EUV light in a soft X-ray range (e.g. a wavelength range from 5 to 15 nm), and uses a total reflection reduction optical system designed under the exposure wavelength (e.g. 13.5nm) and the reflective mask. In addition, the present invention can similarly be applied also to an exposure apparatus that uses charged particle beams such as an electron beam or an ion beam. Furthermore, the linewidth measuring method, the image-forming-state detecting method, the adjustment method, and the exposure method of the present invention can also be applied to a liquid immersion type exposure apparatus in which a space between projection optical system PL and a wafer is filled with a liquid (e.g. pure water or the like), which is disclosed in, for example, the pamphlet of International Publication No. 99/49504 and the like, or an exposure apparatus by a step-and-stitch method, or an exposure apparatus by a proximity method.

Moreover, the exposure apparatus in the embodiment above is not limited to the exposure apparatus used for manufacturing semiconductor devices, but can be an exposure apparatus for manufacturing other devices such as displays (such as liquid crystal display devices), imaging devices (such as CCDs), thin-film magnetic heads, micromachines, DNA chips or reticles (masks), and the present invention can also be applied to such an exposure apparatus. Further, an object on which a pattern should be formed (an object subject to exposure to which an energy beam is irradiated) in the embodiment above is not limited to a wafer, but can be other objects such as a glass plate, a ceramic substrate, a film member, or a mask blank.

Incidentally, in the embodiment above, a transmissive type mask, which is a transmissive substrate on which a predetermined light-shielding pattern (or a phase pattern or a light-attenuation pattern) is formed, is used. Instead of this reticle, however, as is disclosed in, for example, U.S. Patent No. 6,778,257, an electron mask (which is also called a variable shaped mask, an active mask or an image generator, and includes, for example, a DMD (Digital Micromirror Device) that is a type of a non-emission type image display device (spatial light modulator) or the like) on which a light-transmitting pattern, a reflection pattern, or an emission pattern is formed according to electronic data of the pattern that should be exposed can also be used. Further, as is disclosed in, for example, the pamphlet of International Publication No. 2001/035168, the present invention can also be applied to an exposure apparatus (lithography system) that forms device patterns on wafer W by forming interference fringes on wafer W. Moreover, the present invention can also be applied to an exposure apparatus that synthesizes two reticle patterns on a wafer via a projection optical system and almost simultaneously performs double exposure of one shot area on the wafer by one scanning exposure, as is disclosed in, for example, U.S. Patent No. 6,611,316. The point is that any exposure apparatus that exposes an object by generating a pattern image for measurement within an exposure area of an optical system can be employed.

Incidentally, the above disclosures of all the publications, the pamphlets of the International Publications, and the U.S. Patent Application Publications' descriptions, and the U.S. Patents' descriptions that are cited in the description above and related to exposure apparatuses and the like are each incorporated herein by reference.

Semiconductor devices are manufactured through the following steps: a step where the function/performance design of a device is performed; a step where a reticle based on the design step is manufactured; a step where a wafer is manufactured using silicon materials; a step where a pattern of the reticle is transferred onto the wafer with the exposure apparatus of the embodiment described earlier; a device assembly step (including a dicing process, a bonding process, and a packaging process); an inspection step; and the like. In this case, in the lithography step, the exposure method described earlier is executed using the exposure apparatus of the embodiment above and device patterns are formed on the wafer, and therefore, highly-integrated devices can be manufactured with high productivity.

## INDUSTRIAL APPLICABILITY

As is described above, the linewidth measuring method of the present invention is suitable for measuring the linewidth of a line pattern formed on an object. Further, the image-forming-state detecting method of the present invention is suitable for detecting a forming state of an image of a pattern that includes a line pattern formed on an object. Further, the adjustment method of the present invention is suitable for adjusting an optical system. Furthermore, the exposure method and the device manufacturing method are suitable for manufacturing microdevices.

## Claims

1. A linewidth measuring method of measuring a linewidth of a pattern formed on an object, the method comprising:

   an acquisition process in which a pattern area including the pattern formed on the object is imaged, and brightness/darkness information of an image of the pattern area is acquired based on a result of the imaging; and
   a conversion process in which the brightness/darkness information that has been acquired is converted into a linewidth of the pattern based on known conversion information.

2. The linewidth measuring method according to Claim 1, further comprising:

   a process in which the conversion information is obtained, prior to the acquisition process.

3. The linewidth measuring method according to Claim 2, wherein
   in the conversion process, each of a plurality of the pattern areas that are formed respectively at different positions on an object for measurement is respectively imaged, and also a linewidth of a pattern that is included in at least one of the pattern areas that is subject to the imaging is measured using a linewidth measuring device, and the conversion information is obtained based on brightness/darkness information of each of the pattern areas that is obtained from a measurement result of the linewidth and a result of the imaging.

4. The linewidth measuring method according to any one of Claims 1 to 3, wherein
   the conversion information is a function in which the brightness/darkness information serves as an independent variable and the linewidth serves as a dependent variable.

5. The linewidth measuring method according to any one of Claims 1 to 4, wherein
   the brightness/darkness information includes a contrast value of an image of each of the pattern areas.

6. The linewidth measuring method according to Claim 5, wherein
   the contrast value is expressed by a predetermined statistic that includes a deviation of a luminance value of each of pixels regarding each of the pattern areas, with respect to a predetermined reference value.

7. The linewidth measuring method according to Claim 6, wherein
the predetermined reference value is an average value of luminance values of an area where the pattern does not exist on the object.

8. The linewidth measuring method according to one of Claims 6 and 7, wherein
the predetermined statistic is at least one of a variance and a standard deviation of luminance values of the pixels.

9. The linewidth measuring method according to any one of Claims 1 to 4, wherein
the brightness/darkness information includes a ratio between a luminance value of the pixel of an area where the pattern exists and a luminance value of the pixel of an area where no pattern exists, the areas being in each of the pattern areas.

10. A linewidth measuring method of measuring a linewidth of a pattern formed on an object, the method comprising:

detecting a pattern area that includes the pattern formed on the object with a first measurement device, and acquiring brightness/darkness information of the pattern area; and
determining a linewidth of the pattern based on conversion information that is obtained using a second measurement device different from the first measurement device, and on the brightness/darkness information.

11. The linewidth measuring method according to Claim 10, wherein
the first measurement device has a resolution lower than the linewidth of the pattern.

12. The linewidth measuring method according to Claim 11, wherein
the first measurement device detects the pattern area in an imaging method.

13. The linewidth measuring method according to any one of Claims 10 to 12, wherein
the second measurement device has a resolution higher than the linewidth of the pattern.

14. The linewidth measuring method according to Claim 13, wherein
the second measurement device includes an electron microscope.

15. The linewidth measuring method according to any one of Claims 10 to 14, wherein
the conversion information is determined based on the brightness/darkness information obtained from the first measurement device and linewidth information obtained from the second measurement device, the brightness/darkness information and the linewidth information being obtained by detecting a plurality of patterns having different linewidths with the first and the second measurement devices, respectively.

16. The linewidth measuring method according to any one of Claims 10 to 15, wherein
the brightness/darkness information includes contrast information of the pattern area.

17. The linewidth measuring method according to any one of Claims 10 to 16, wherein
the brightness/darkness information includes information related to a difference in intensity between an area where the pattern exists and an area where no pattern exists, the areas being in the pattern area.

18. An image-forming-state detecting method, comprising:

a process in which an object is exposed with an energy beam via an optical system, and an image of a pattern is formed on the object;
a process in which a linewidth of the image of the pattern formed on the object is measured in the linewidth measuring method according to any one of Claims 1 to 17; and
a process in which a forming state of the image of the pattern is detected based on a result of the measurement.

19. The image-forming-state detecting method according to Claim 18, wherein
the pattern includes a plurality of line patterns with a predetermined spacing therebetween.

20. An adjustment method, comprising:

a process in which a forming state of an image of a pattern formed on an object is detected in the image-forming-state detecting method according to one of Claims 18 and 19; and
a process in which an optical system is adjusted based on a results of the detection.

21. An exposure method of exposing an object with an energy beam via an optical system and forming an image of a pattern on the object, the method comprising:

a process in which a forming state of the image of the pattern formed at a plurality of positions on the object is detected using the image-forming-state detecting method according to one of Claims 18 and 19; and
a process in which the forming state of the image of the pattern during the exposure is adjusted based on a result of the detection.

22. An exposure method of exposing an object with an energy beam via an optical system and forming an image of a pattern on the object, the method comprising:

a process in which a linewidth of the image of the pattern formed on the object is measured in the linewidth measuring method according to any one of Claims 1 to 17; and
a process in which a forming state of the image of the pattern during the exposure is adjusted based on a result of the measurement.

23. The exposure method according to one of Claims 21 and 22, wherein
the adjustment of the forming state of the image is performed by adjusting an optical performance of the optical system.

24. The exposure method according to any one of Claims 21 to 23, wherein
the adjustment of the forming state of the image is performed by adjusting a total energy amount of the energy beam irradiated onto the object.

25. The exposure method according to any one of Claims 21 to 24, wherein
the exposure is performed by synchronously scanning a mask on which the pattern is formed and the object relative to the energy beam, and
the adjustment of the forming state of the image is performed by adjusting a synchronous state of the mask and the object.

26. An exposure method of exposing an object with an energy beam and forming a pattern on the object, the method comprising:

measuring a linewidth of the pattern formed on the object by the exposure in the linewidth measuring method according to any one of Claims 1 to 17; and
determining an exposure condition of the object based on the linewidth that has been measured.

27. The exposure method according to Claim 26, wherein
the pattern whose linewidth is measured is formed on an object for measurement, and a pattern is formed on an object for device manufacturing under the exposure condition that has been determined.

28. A device manufacturing method, including
a lithography process in which a device pattern is formed on an object using the exposure method according to any one of Claims 21 to 27.

29. A device manufacturing method that includes a process of exposing an object with an energy beam and a process of processing the object that has been exposed, the method comprising:

measuring a linewidth of a pattern formed on the object by the exposure in the linewidth measuring method according to any one of Claims 1 to 17; and
determining a processing condition of the object in at least one of the exposing process and the processing process, based on the linewidth that has been measured.

*Fig. 1*

## Fig. 2

## Fig. 3

*Fig. 4*

```
                                                              S1
┌──────────────────────────────────────────────┐
│   MAKE A SAMPLE FOR LINEWIDTH MEASUREMENT      │
└──────────────────────────────────────────────┘
                                                              S2
┌──────────────────────────────────────────────┐
│      MEASURE CONTRAST USING THE SAMPLE         │
└──────────────────────────────────────────────┘
                                                              S3
┌──────────────────────────────────────────────┐
│        MEASURE A LINEWIDTH OF AN IMAGE OF      │
│            A PATTERN USING SEM                 │
└──────────────────────────────────────────────┘
                                                              S4
┌──────────────────────────────────────────────┐
│          CREATE A FUNCTION FOR CONVERTING      │
│         THE CONTRAST INTO THE LINEWIDTH        │
└──────────────────────────────────────────────┘
                                                              S5
┌──────────────────────────────────────────────┐
│    FORWARD THE CREATED CONVERSION FUNCTION     │
│           TO AN EXPOSURE APPRATUS              │
└──────────────────────────────────────────────┘
                                                              S6
┌──────────────────────────────────────────────┐
│      TRANSFER A DEVICE PATTERN ON A WAFER      │
└──────────────────────────────────────────────┘
                                                              S7
┌──────────────────────────────────────────────┐
│              DEVELOP THE WAFER                 │
└──────────────────────────────────────────────┘
                                                              S8
┌──────────────────────────────────────────────┐
│  MEASURE A RESIST IMAGE ON THE DEVELOPED WAFER,│
│      AND COMPUTE A CONTRAST VALUE PER          │
│            MEASUREMENT MARK AREA               │
└──────────────────────────────────────────────┘
                                                              S9
┌──────────────────────────────────────────────┐
│          CONVERT THE CONTRAST VALUE INTO       │
│  THE LINEWIDTH USING THE CONVERSION FUNCTION   │
└──────────────────────────────────────────────┘
                                                              S10
┌──────────────────────────────────────────────┐
│        ADJUST A TRANSFER STATE BASED ON        │
│   COMPUTATION RESULT OF THE LINEWIDTH,         │
│     AND TRANSFER THE DEVICE PATERN TO          │
│     A PREDETERMINED NUNBER OF WAFERS           │
└──────────────────────────────────────────────┘
```

*Fig. 5*

```
                        ┌──────────┐
                        │  START   │
                        └────┬─────┘
                             │
              ┌──────────────┴────────────────┐
              │  LOAD A MEASUREMENT RETICLE    │ ── 202
              └──────────────┬────────────────┘
                             │
              ┌──────────────┴────────────────┐
              │  PREPARATORY OPERATIONS        │ ── 204
              │  SUCH AS RETICLE ALIGHNMENT    │
              └──────────────┬────────────────┘
                             │
              ┌──────────────┴────────────────┐
              │       LOAD A WAFER             │ ── 206
              └──────────────┬────────────────┘
                             │
                      ┌──────┴──────┐
                      │   i ← 1      │ ── 208
                      └──────┬──────┘
                             │
         ┌───────────────────┤
         │   ┌───────────────┴───────────────────────┐
         │   │ MOVE TO AN ACCELERATION STARTING       │ ── 212
         │   │ POSITION FOR EXPOSURE OF iᵗʰ SHOT      │
         │   └───────────────┬───────────────────────┘
         │                   │
  ┌──────┴─────┐   ┌─────────┴──────────────────────┐
  │  i ← i+1   │   │ SCANNING EXPOSURE OF iᵗʰ SHOT  │ ── 214
  └──────▲─────┘   └─────────┬──────────────────────┘
         │                   │
         │         N   ◇ i = M? ◇ ── 216
         └─────────────┘    │
                          Y │
              ┌─────────────┴──────────────────┐
              │  CARRY A WAFER W_T TO A C/D     │ ── 220
              └─────────────┬──────────────────┘
                            │
              ┌─────────────┴──────────────────┐
              │  INSTRUCT DEVELOPMENT          │ ── 222
              │  OF WAFER W_T                  │
              └─────────────┬──────────────────┘
                            │
         ┌──────────────────┤
         │  N   ◇ DEVELOPMENT IS COMPLETED? ◇ ── 224
         └──────────┘       │
                          Y │ ── 226
              ┌─────────────┴──────────────────┐
              │ NOTIFY OF DEVELOPMENT COMPLETION│ ── 226
              └─────────────┬──────────────────┘
                            │
                          ( A )
```

218

*Fig. 6*

## Fig. 7

232

START

$i \leftarrow 1$ — 500

$n \leftarrow 1$ — 502

POSITION A WAFER AT A DETECTION POSITION OF A RESIST IMAGE $MP_{i,n}'$ — 504

CAPTURE IMAGING DATA — 506

CREAT AN IMAGING DATA FILE — 508

DETECT AN OUTER EDGE OF AN AREA CORRESPONDING TO RESIST IMAGE $MP_{i,n}'$ — 510

COMPUTES A CONTRAST VALUE PER MEASUREMENT MARK AREA OF THE AREA CORRESONDING TO RESIST IMAGE $MP_{i,n}'$ — 512

520 $i \leftarrow i + 1$

516 $n \leftarrow n + 1$

$n = K?$ — 514  N

Y

$i = M?$ — 518  N

Y

COMPUTE AND STORE AN AVERAGE VALUE AMONG A PLURALITY OF SHOTS OF THE CONTRAST VALUES PER MEASUREMENT MARK AREA, REGARDING EACH RESIST IMAGE — 522

RETURN

*Fig. 8*

*Fig. 9*

Fig. 10

*Fig. 11*

*Fig. 12A*

*Fig. 12B*

## INTERNATIONAL SEARCH REPORT

| | International application No. |
|---|---|
| | PCT/JP2007/068930 |

A. CLASSIFICATION OF SUBJECT MATTER
*G01B11/02*(2006.01)i, *G03F7/20*(2006.01)i, *H01L21/027*(2006.01)i

According to International Patent Classification (IPC) or to both national classification and IPC

B. FIELDS SEARCHED

Minimum documentation searched (classification system followed by classification symbols)
G01B11/00-11/30, G03F7/20-7/24, G03F9/00-9/02, H01L21/027

Documentation searched other than minimum documentation to the extent that such documents are included in the fields searched
Jitsuyo Shinan Koho       1922-1996   Jitsuyo Shinan Toroku Koho   1996-2007
Kokai Jitsuyo Shinan Koho   1971-2007   Toroku Jitsuyo Shinan Koho   1994-2007

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 7-243814 A  (Fujitsu Ltd.),<br>19 September, 1995 (19.09.95),<br>Par. Nos. [0019] to [0033]; Figs. 1 to 5<br>(Family: none) | 1-3,10-15<br>4-9,16-29 |
| Y | JP 2002-93697 A  (Tokyo Electron Ltd.),<br>29 March, 2002 (29.03.02),<br>Par. Nos. [0020] to [0125]; Figs. 1 to 16<br>& US 2002/0005496 A1 | 4-9,16-29 |
| A | JP 7-332936 A  (Oki Electric Industry Co.,<br>Ltd.),<br>22 December, 1995 (22.12.95),<br>Full text; Figs. 1 to 6<br>(Family: none) | 1-29 |

☒  Further documents are listed in the continuation of Box C. ☐  See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 07 November, 2007 (07.11.07) | 20 November, 2007 (20.11.07) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.

PCT/JP2007/068930

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2005-188944 A  (Tokyo Electron Ltd.),<br>14 July, 2005 (14.07.05),<br>Full text; Figs. 1 to 11<br>& US 2005/0141891 A1 | 1-29 |
| A | JP 2005-294742 A  (Nikon Corp.),<br>20 October, 2005 (20.10.05),<br>Full text; Figs. 1 to 14<br>(Family: none) | 1-29 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4908656 A
- US 20030025890 A
- JP 6283403 A
- US 5448332 A
- JP 7176468 A
- US 5646413 A
- US 20040179190 A
- US 2004179190 A
- WO 9949504 A
- US 6778257 B
- US 6611316 B